(19) Europäisches Patentamt
European Patent Office
Office européen des brevets

(11) **EP 4 636 445 A1**

(12) **EUROPEAN PATENT APPLICATION**
published in accordance with Art. 153(4) EPC

(43) Date of publication:
**22.10.2025 Bulletin 2025/43**

(21) Application number: **23903209.7**

(22) Date of filing: **17.11.2023**

(51) International Patent Classification (IPC):
***G02B 5/30*** *(2006.01)* ***G02F 1/1335*** *(2006.01)*
***G09F 9/00*** *(2006.01)* ***H10K 59/10*** *(2023.01)*
***H10K 59/50*** *(2023.01)*

(52) Cooperative Patent Classification (CPC):
**G02F 1/1335; G02B 5/30; G02F 1/13363; G02F 1/133633; G09F 9/00; H10K 59/10; H10K 59/50**

(86) International application number:
**PCT/JP2023/041506**

(87) International publication number:
**WO 2024/127911 (20.06.2024 Gazette 2024/25)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.12.2022 JP 2022199432**
**09.06.2023 JP 2023095514**

(71) Applicant: **FUJIFILM Corporation**
**Tokyo 106-8620 (JP)**

(72) Inventors:
- **MITOBE, Fumitake**
**Minamiashigara-shi, Kanagawa 250-0193 (JP)**
- **NISHIMURA, Naoya**
**Minamiashigara-shi, Kanagawa 250-0193 (JP)**
- **KOITO, Naoki**
**Minamiashigara-shi, Kanagawa 250-0193 (JP)**

(74) Representative: **Klunker IP Patentanwälte PartG mbB**
**Destouchesstraße 68**
**80796 München (DE)**

(54) **OPTICAL LAMINATE AND IMAGE DISPLAY DEVICE**

(57) An object of the present invention is to provide an optical laminate and an image display device that can suppress tinting of a display screen in a case of being used in an image display device having a viewing angle switching function. An optical laminate of the present invention includes in the following order, a first light absorption anisotropic layer; a liquid crystal cell; and a second light absorption anisotropic layer, in which at least one of the first light absorption anisotropic layer or the second light absorption anisotropic layer is a specific light absorption anisotropic layer satisfying all of the following Requirements 1 to 3.

Requirement 1: Contain a dichroic substance.

Requirement 2: An angle between a transmittance central axis of a light absorption anisotropic layer and a normal direction of a surface of a light absorption anisotropic layer is 0° or more and 40° or less.

Requirement 3: A difference in alignment degrees of a light absorption anisotropic layer at wavelengths of 450 nm, 550 nm, and 650 nm is 0.025 or less.

FIG. 1

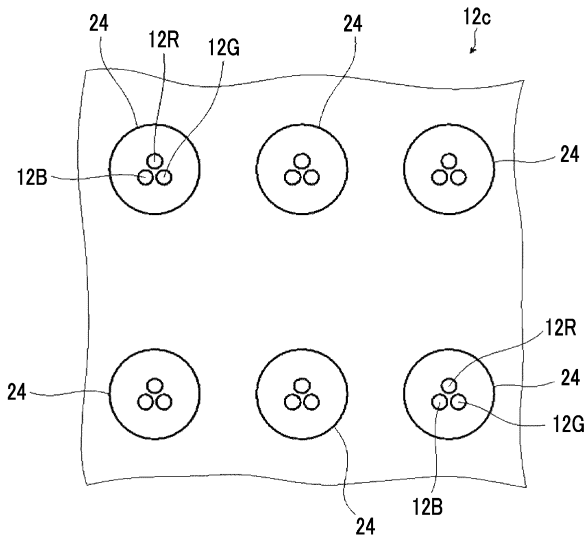


EP 4 636 445 A1

## Description

## BACKGROUND OF THE INVENTION

1. Field of the Invention

The present invention relates to an optical laminate and an image display device.

2. Description of the Related Art

Image display devices such as liquid crystal display devices and organic EL display devices are frequently used as displays for smartphones, notebook computers, and the like. In recent years, since these devices have been thinner and lighter and are thus easily carried, the devices are used in public places, for example, transportation facilities such as trains and aircraft, libraries, and restaurants in many cases. Therefore, due to the need to protect personal information, confidential information, and the like, there is a demand for a technique for preventing the display contents of image display devices from being peeped by others.

For example, JP2021-210359A describes an optical laminate including, in the following order, at least a first light absorption anisotropic layer, a refractive index anisotropic layer containing a liquid crystal compound having one or more twisted structures, and a second light absorption anisotropic layer, in which the refractive index anisotropic layer is a liquid crystal cell (for example, an electrically birefringent switchable TN liquid crystal cell) ([claim 1], [claim 4], and [claim 5]).

## SUMMARY OF THE INVENTION

The present inventors have applied the optical laminate described in JP2021-210359A to an image display device and evaluated the characteristics thereof, and as a result, they have found that in a case where the viewing angle is switched using a liquid crystal cell as the refractive index anisotropic layer, there is room for improvement in the tint of the display screen as compared with an image display device having no viewing angle switching function.

Therefore, an object of the present invention is to provide an optical laminate and an image display device that can suppress tinting of a display screen in a case of being used in an image display device having a viewing angle switching function.

As a result of intensive studies to achieve the above-described object, the present inventors have found that in a case where an optical laminate including a specific light absorption anisotropic layer satisfying a predetermined requirement in at least one of a first light absorption anisotropic layer or a second light absorption anisotropic layer is used together with a liquid crystal cell, the tinting of a display screen can be suppressed in a case of being applied to an image display device having a viewing angle switching function, and have completed the present invention.

That is, the present inventors have found that the above-described object can be achieved by employing the following configurations.

[1] An optical laminate comprises in the following order, a first light absorption anisotropic layer; a liquid crystal cell; and a second light absorption anisotropic layer,
in which at least one of the first light absorption anisotropic layer or the second light absorption anisotropic layer is a specific light absorption anisotropic layer satisfying all of the following requirements 1 to 3,

Requirement 1: Contain a dichroic substance,
Requirement 2: An angle between a transmittance central axis of a light absorption anisotropic layer and a normal direction of a surface of a light absorption anisotropic layer is 0° or more and 40° or less, and
Requirement 3: A difference in alignment degrees of a light absorption anisotropic layer at wavelengths of 450 nm, 550 nm, and 650 nm is 0.025 or less.

[2] The optical laminate according [1], in which a transmittance central axis in any one of the first light absorption anisotropic layer or the second light absorption anisotropic layer is present in an in-plane direction of the light absorption anisotropic layer.
[3] The optical laminate according to [1] or [2], in which a haze value of the specific light absorption anisotropic layer is 0.3% or less.
[4] The optical laminate according to any one of [1] to [3], in which the specific light absorption anisotropic layer contains a polymer liquid crystal compound.
[5] The optical laminate according to any one of [1] to [4], in which the specific light absorption anisotropic layer contains a fluorine-based vertical alignment agent having a boronic acid group.

[6] The optical laminate according to any one of [1] to [5], in which the liquid crystal cell is in a VA mode, and an in-plane phase difference at a wavelength of 550 nm is switchable between 0 nm and 120 to 160 nm or between 0 nm and 250 to 300 nm.
[7] The optical laminate according to any one of [1] to [5], in which the liquid crystal cell is in an IPS mode and has an in-plane phase difference of 120 to 160 nm or 250 to 300 nm at a wavelength of 550 nm.
[8] The optical laminate according to any one of [1] to [5], in which the liquid crystal cell is in a TN mode, and a twisted angle of alignment is switchable between 0° and 90° or between 0° and 270°.
[9] An image display device having a viewing angle switching function, the image display device comprises the optical laminate according to any one of [1] to [8].
[10] The image display device according to [9], in which viewing angles of a plurality of regions in a display screen are independently switchable.

According to the present invention, it is possible to provide an optical laminate and an image display device that can suppress tinting of a display screen in a case of being used in an image display device having a viewing angle switching function.

## BRIEF DESCRIPTION OF THE DRAWING

Fig. 1 is a conceptual diagram showing an example of an embodiment of an inorganic EL light emitting element (so-called micro light-emitting diode (LED)).

## DESCRIPTION OF THE PREFERRED EMBODIMENTS

Hereinafter, the present invention will be described in detail.
The following description of configuration requirements is based on representative embodiments of the present invention, but the present invention is not limited to the embodiments.
In the present specification, a numerical range expressed using "to" means a range including numerical values before and after "to" as a lower limit value and an upper limit value.
In addition, in the present specification, the terms parallel and orthogonal do not mean only strict parallel and strict orthogonal, respectively, but rather a range of parallel ± 5° and a range of orthogonal ± 5°, respectively.
In addition, in the present specification, as each component, a substance corresponding to each component may be used alone, or two or more kinds of substances may be used in combination. Here, in a case where two or more kinds of substances are used in combination for each component, the content of the component refers to a total content of the substances used in combination unless otherwise specified.
In addition, in the present specification, "(meth)acrylate" represents "acrylate" or "methacrylate", "(meth)acryl" represents "acryl" or "methacryl", and "(meth)acryloyl" represents "acryloyl" or "methacryloyl".
In addition, in the present specification, Re(λ) and Rth(λ1) respectively represent an in-plane retardation at a wavelength λ and a thickness-direction retardation at a wavelength λ. Unless otherwise specified, the wavelength λ is 550 nm.
In the present invention, Re(λ) and Rth(λ) are values measured at the wavelength of λ in AxoScan (manufactured by Axometrics, Inc.). By inputting an average refractive index ((nx + ny + nz)/3) and a film thickness (d (μm)) to AxoScan, the followings are calculated.

Slow Axis Direction (°)

$$Re(\lambda) = R0(\lambda)$$

$$Rth(\lambda) = ((nx + ny)/2 - nz) \times d$$

Although R0(λ) is displayed as a numerical value calculated by AxoScan, it means Re(λ).
In the present specification, the refractive indices nx, ny, and nz are measured using an Abbe refractometer (NAR-4T, manufactured by Atago Co., Ltd.) and a sodium lamp (λ = 589 nm) as a light source. In addition, in the measurement of wavelength dependence, it can be measured with a multi-wavelength Abbe refractometer DR-M2 (manufactured by Atago Co., Ltd.) in combination with a dichroic filter.
In addition, values in Polymer Handbook (John Wiley & Sons, Inc.) and catalogs of various optical films can be

used. Examples of values of the average refractive indices of main optical films are as follows: cellulose acylate (1.48), cycloolefin polymer (1.52), polycarbonate (1.59), polymethylmethacrylate (1.49), and polystyrene (1.59).

[Optical Laminate]

An optical laminate according to the embodiment of the present invention has a first light absorption anisotropic layer, a liquid crystal cell, and a second light absorption anisotropic layer in this order.
In addition, in the optical laminate according to the embodiment of the present invention, at least one of the first light absorption anisotropic layer or the second light absorption anisotropic layer is a specific light absorption anisotropic layer specifying all of the following Requirements 1 to 3.
Requirement 1: Contain a dichroic substance.
Requirement 2: An angle between a transmittance central axis of a light absorption anisotropic layer and a normal direction of a surface of a light absorption anisotropic layer is 0° or more and 40° or less.
Requirement 3: A difference in alignment degrees of a light absorption anisotropic layer at wavelengths of 450 nm, 550 nm, and 650 nm is 0.025 or less.
Here, the transmittance central axis of the light absorption anisotropic layer means a direction in which the highest transmittance is exhibited in a case where the transmittance is measured by changing the inclination angle (polar angle) and the inclination direction (azimuthal angle) with respect to the normal direction of the surface of the light absorption anisotropic layer.
Specifically, the Mueller matrix at a wavelength of 550 nm is measured using AxoScan (manufactured by Axometrics, Inc.). More specifically, in the measurement, an azimuthal angle at which the transmittance central axis is inclined is first searched for, the Mueller matrix at a wavelength of 550 nm is measured while the polar angle which is the angle with respect to the normal direction of the surface of the light absorption anisotropic layer is changed from - 70° to 70° at intervals of 1° in the surface (the plane that has the transmittance central axis and is orthogonal to the layer surface) having the normal direction of the light absorption anisotropic layer along the azimuthal angle, and the transmittance of the light absorption anisotropic layer is derived. As a result, the direction in which the highest transmittance is exhibited is defined as the transmittance central axis.
Further, the transmittance central axis means a direction (the major axis direction of a molecule) of the absorption axis of the dichroic substance contained in each light absorption anisotropic layer.
In addition, as the alignment degree of the light absorption anisotropic layer at wavelengths of 450 nm, 550 nm, and 650 nm, values calculated by the following method are adopted.
Specifically, the Mueller matrix is measured at polar angles in a range of -70° to 70° at intervals of 5° in the in-plane slow axis direction using AxoScan (manufactured by Axometrics, Inc.), and kx(λ), ky(λ), and kz(λ) are obtained by fitting.
Next, the absorption anisotropies Ao(λ) and Ae(λ) are obtained according to the following equations (A) to (D), and the alignment degree S is calculated according to the following equation (E).

$$To(\lambda) = EXP\{-4 \times \pi \times (kx(\lambda) + ky(\lambda))/2 \times d/\lambda\} \qquad (A)$$

$$Te(\lambda) = EXP\{-4 \times \pi \times kz(\lambda) \times d/\lambda\} \qquad (B)$$

$$Ao(\lambda) = -\log(To(\lambda)) \qquad (C)$$

$$Ae(\lambda) = -\log(Te(\lambda)) \qquad (D)$$

$$\text{Alignment degree } S(\lambda) = [Ao(\lambda)/Ae(\lambda) - 1]/[Ao(\lambda)/Ae(\lambda) + 2] \qquad (E)$$

Here, d represents a film thickness (nm) of the light absorption anisotropic layer, To(λ) and Te(λ) represent transmittance, and Ao(λ) and Ae(λ) represent absorbance.
The difference in the alignment degrees (0.025 or less) defined in Requirement 3 described above refers to the maximum difference among the difference in the alignment degrees at each of the wavelengths of 450 nm and 550 nm, the difference in the alignment degrees at each of the wavelengths of 450 nm and 650 nm, and the difference in the alignment degrees at each of the wavelengths of 550 nm and 650 nm.
In the present invention, as described above, in a case where an optical laminate in which at least one of the first light absorption anisotropic layer or the second light absorption anisotropic layer is a specific light absorption anisotropic layer is used, it is possible to suppress the tinting of the display screen in a case of being applied to an image display device

having a viewing angle switching function.

Although the details thereof are not clear, the present inventors have presumed as follows.

That is, it is considered that, since the specific light absorption anisotropic layer satisfies the above-described Requirements 1 to 3 (particularly, Requirement 3), the influence of the state of the phase difference in the liquid crystal cell (for example, a state where the in-plane phase difference is $\lambda/2$) is small, that is, the variation in the absorption amount of blue light, green light, and red light in the light absorption anisotropic layer is small, and thus the tinting of the display screen can be suppressed.

Hereinafter, each layer included in the optical laminate according to the embodiment of the present invention will be described in detail.

[First Light Absorption Anisotropic Layer and Second Light Absorption Anisotropic Layer]

The first light absorption anisotropic layer and the second light absorption anisotropic layer included in the optical laminate according to the embodiment of the present invention are not particularly limited as long as at least one of the first light absorption anisotropic layer or the second light absorption anisotropic layer is a specific light absorption anisotropic layer. The first light absorption anisotropic layer and the second light absorption anisotropic layer may be any of an aspect in which both the first light absorption anisotropic layer and the second light absorption anisotropic layer are specific light absorption anisotropic layers; an aspect in which the first light absorption anisotropic layer is a specific light absorption anisotropic layer and the second light absorption anisotropic layer is a light absorption anisotropic layer (hereinafter, also referred to as "other light absorption anisotropic layer") which does not correspond to the specific light absorption anisotropic layer; and an aspect in which the first light absorption anisotropic layer is the other light absorption anisotropic layer and the second light absorption anisotropic layer is a specific light absorption anisotropic layer.

<Specific Light Absorption Anisotropic Layer>

As described above, the specific light absorption anisotropic layer is a light absorption anisotropic layer containing a dichroic substance (refer to Requirement 1), and is preferably a light absorption anisotropic layer containing a liquid crystal compound together with a dichroic substance, and more preferably a layer in which the alignment states of the liquid crystal compound and the dichroic substance are fixed.

In addition, as described above, the angle formed by the transmittance central axis of the specific light absorption anisotropic layer and the normal direction of the surface of the specific light absorption anisotropic layer is 0° or more and 40° or less (refer to Requirement 2), but from the reason that the tinting of the display screen can be further suppressed, the angle is preferably 0° or more and 35° or less, more preferably 0° or more and 20° or less, and still more preferably 0° or more and less than 15°.

Further, as described above, the difference ($\Delta S$) in the alignment degree of the specific light absorption anisotropic layer at wavelengths of 450 nm, 550 nm, and 650 nm is 0.025 or less (refer to Requirement 3), but from the reason that the tinting of the display screen can be further suppressed, the difference ($\Delta S$) is preferably 0.020 or less and more preferably 0.010 to 0.000.

In the present invention, from the reason that the image is easily identified, the haze value of the specific light absorption anisotropic layer is preferably 0.3% or less.

Here, the haze value refers to haze measured in accordance with "Method of Obtaining Haze of Plastic - Transparent Materials" of JIS K7136:2000, and refers to a value measured with a haze meter (for example, NDH2000 (manufactured by Nippon Denshoku Industries Co., Ltd.)) in an environment of 25°C and a relative humidity of 55%.

<Other Light Absorption Anisotropic Layers>

The other light absorption anisotropic layer is a light absorption anisotropic layer that does not correspond to the specific light absorption anisotropic layer, and for example, an absorption type polarizer and a reflective type polarizer known in the related art can be used.

Here, an iodine-based polarizer, a dye-based polarizer using a dichroic dye, a polyenebased polarizer, or the like is used as the absorption type polarizer. The iodine-based polarizer and the dye-based polarizer include a coating type polarizer and a stretching type polarizer, and any one of these polarizers can be applied. However, a polarizer which is produced by allowing polyvinyl alcohol to adsorb iodine or a dichroic dye and performing stretching is preferable.

A polarizer in which thin films having different birefringence are laminated, a wire grid type polarizer, a polarizer in which a cholesteric liquid crystal having a selective reflection range and a 1/4 wavelength plate are combined, or the like is used as the reflective type polarizer.

In addition, similar to the specific light absorption anisotropic layer, the other light absorption anisotropic layer is preferably a light absorption anisotropic layer containing a dichroic substance, more preferably a light absorption

anisotropic layer containing a dichroic substance and a liquid crystal compound, and still more preferably a layer in which the alignment states of the liquid crystal compound and the dichroic substance are fixed.

In addition, the transmittance central axis of the other light absorption anisotropic layer may be present in the in-plane direction of the other light absorption anisotropic layer.

In addition, similar to the specific light absorption anisotropic layer, in the other light absorption anisotropic layer, the difference in alignment degree at wavelengths of 450 nm, 550 nm, and 650 nm is preferably 0.025 or less, more preferably 0.020 or less, and still more preferably 0.010 to 0.000.

<Dichroic Substance>

The dichroic substance contained in the specific light absorption anisotropic layer and the dichroic substance which may be contained in the other light absorption anisotropic layer both mean a substance having an absorbance that varies depending on a direction. In addition, the dichroic substance may or may not exhibit liquid crystallinity.

The dichroic substance is not particularly limited, and examples thereof include a visible light absorbing substance (dichroic coloring agent), a light emitting substance (fluorescent substance and phosphorescent substance), an ultraviolet absorbing substance, an infrared absorbing substance, a non-linear optical substance, a carbon nanotube, and an inorganic substance (for example, quantum rod). Further, known dichroic substances (dichroic coloring agents) of the related art can be used.

Specific examples thereof include those described in paragraphs [0067] to [0071] of JP2013-228706A, paragraphs [0008] to [0026] of JP2013-227532A, paragraphs [0008] to [0015] of JP2013-209367A, paragraphs [0045] to [0058] of JP2013-14883A, paragraphs [0012] to [0029] of JP2013-109090A, paragraphs [0009] to [0017] of JP2013-101328A, paragraphs [0051] to [0065] of JP2013-37353A, paragraphs [0049] to [0073] of JP2012-63387A, paragraphs [0016] to [0018] of JP1999-305036A (JP-H11-305036A), paragraphs [0009] to [0011] of JP2001-133630A, [0030] to [0169] of JP2011-215337A, paragraphs [0021] to [0075] of JP2010-106242A, paragraphs [0011] to [0025] of JP2010-215846A, paragraphs [0017] to [0069] of JP2011-048311A, paragraphs [0013] to [0133] of JP2011-213610A, paragraphs [0074] to [0246] of JP2011-237513A, paragraphs [0005] to [0051] of JP2016-006502A, paragraphs [0014] to [0032] of JP2018-053167A, paragraphs [0014] to [0033] of JP2020-11716A, paragraphs [0005] to [0041] of WO2016/060173A, paragraphs [0008] to [0062] of WO2016/136561A, paragraphs [0014] to [0033] of WO2017/154835A, paragraphs [0014] to [0033] of WO2017/154695A, paragraphs [0013] to [0037] of WO2017/195833A, paragraphs [0014] to [0034] of WO2018/164252A, paragraphs [0021] to [0030] of WO2018/186503A, paragraphs [0043] to [0063] of WO2019/189345A, paragraphs [0043] to [0085] of WO2019/225468A, paragraphs [0050] to [0074] of WO2020/004106A, and paragraphs [0015] to [0038] of WO2021/044843A.

As the dichroic substance, a dichroic azo coloring agent compound is preferable.

The dichroic azo coloring agent compound means an azo coloring agent compound having different absorbances depending on directions. The dichroic azo coloring agent compound may or may not exhibit liquid crystallinity. In a case where the dichroic azo coloring agent compound exhibits liquid crystallinity, any of nematic properties or smectic properties may be exhibited. The temperature range in which the liquid crystal phase is exhibited is preferably room temperature (approximately 20°C to 28°C) to 300°C, and from the viewpoint of handleability and manufacturing suitability, more preferably 50°C to 200°C.

In the present invention, from the viewpoint of tint adjustment, it is preferable to use at least at least one coloring agent compound (first dichroic azo coloring agent compound) having a maximal absorption wavelength in a wavelength range of 560 to 700 nm and at least one coloring agent compound (second dichroic azo coloring agent compound) having a maximal absorption wavelength in a wavelength range of 455 nm or more and less than 560 nm.

In the present invention, three or more kinds of dichroic azo coloring agent compounds may be used in combination. For example, from the viewpoint of making color of the specific light absorption anisotropic layer and color of the other light absorption anisotropic layer (hereinafter, in a case where a particular distinction is not required, these are collectively referred to as "light absorption anisotropic layer") close to black, it is preferable to use the first dichroic azo coloring agent compound, the second dichroic azo coloring agent compound, and at least one coloring agent compound having a maximal absorption wavelength in a wavelength range of 380 nm or more and less than 455 nm (third dichroic azo coloring agent compound) in combination.

In the present invention, the dichroic azo coloring agent compound preferably has a crosslinkable group.

Examples of the crosslinkable group include a (meth)acryloyl group, an epoxy group, an oxetanyl group, and a styryl group, and among these, a (meth)acryloyl group is preferable.

The content of the dichroic substance is not particularly limited, but due to the reason that the alignment degree of the formed light absorption anisotropic layer is further increased, it is preferably 3% by mass or more, more preferably 8% by mass or more, still more preferably 10% by mass or more, and particularly preferably 10% to 30% by mass with respect to the total mass of the light absorption anisotropic layer. In a case where a plurality of dichroic substances are used in

combination, the total amount of the plurality of dichroic substances is preferably within the above range.

In particular, from the reason that the difference in the alignment degrees of the light absorption anisotropic layer at the wavelengths of 450 nm, 550 nm, and 650 nm to be 0.025 or less is facilitated, the content of the first dichroic azo coloring agent compound is preferably 9% to 12% by mass with respect to the total mass of the light absorption anisotropic layer, the content of the second dichroic azo coloring agent compound is preferably 1% to 2% by mass with respect to the total mass of the light absorption anisotropic layer, and the content of the third dichroic azo coloring agent compound is preferably 4% to 7% by mass with respect to the total mass of the light absorption anisotropic layer.

<Liquid Crystal Compound>

As described above, the light absorption anisotropic layer preferably contains a liquid crystal compound. In this manner, the dichroic substance can be aligned with a higher alignment degree while the precipitation of the dichroic substance is suppressed.

Both a polymer liquid crystal compound and a low-molecular-weight liquid crystal compound can be used as the liquid crystal compound, and particularly, a polymer liquid crystal compound is preferably used from the viewpoint of increasing the alignment degree of the specific light absorption anisotropic layer.

Further, a polymer liquid crystal compound and a low-molecular-weight liquid crystal compound may be used in combination as the liquid crystal compound.

Here, the "polymer liquid crystal compound" refers to a liquid crystal compound having a repeating unit in the chemical structure.

In addition, the "low-molecular-weight liquid crystal compound" refers to a liquid crystal compound having no repeating unit in the chemical structure.

Examples of the polymer liquid crystal compound include thermotropic liquid crystal polymers described in JP2011-237513A and polymer liquid crystal compounds described in paragraphs [0012] to [0042] of WO2018/199096A.

Examples of the low-molecular-weight liquid crystal compound include liquid crystal compounds described in paragraphs [0072] to [0088] of JP2013-228706A. Among these, a smectic liquid crystal compound is preferable.

Here, examples of the smectic phase include a smectic A phase and a smectic C phase, and a higher-order smectic phase (such as a smectic B phase, a smectic E phase, a smectic F phase, a smectic G phase, a smectic H phase, a smectic I phase, a smectic J phase, a smectic K phase, and a smectic L phase) may also be employed.

In addition, the liquid crystal compound may exhibit a nematic phase in addition to the smectic phase.

In the present invention, from the reason that the contrast is higher, it is preferable that the liquid crystal compound is a liquid crystal compound exhibiting any liquid crystal state of a smectic B phase, a smectic E phase, a smectic F phase, a smectic G phase, a smectic H phase, a smectic I phase, a smectic J phase, a smectic K phase, or a smectic L phase.

As the smectic liquid crystal compound, a compound represented by Formula (A-1) is preferable.

Formula (A-1) Q1-V1-SP1-X1-(Ma-La)na-X2-SP2-V2-Q2

In Formula (A-1), Q1 and Q2 each independently represent a polymerizable group.

In addition, V1, V2, X1, and X2 each independently represent a single bond or a divalent linking group.

In addition, SP1 and SP2 each independently represent a divalent spacer group.

In addition, Ma represents an aromatic ring, an aliphatic ring, or a heterocyclic ring, which may have a substituent. Here, a plurality of Ma's may be the same or different from each other.

In addition, La represents a single bond or a divalent linking group. Note that a plurality of La's may be the same or different from each other.

In addition, na represents an integer of 2 to 10.

As the polymerizable group represented by Q1 and Q2, a polymerizable group which is radically polymerizable (radically polymerizable group) or a polymerizable group which is cationically polymerizable (cationically polymerizable group) is preferable.

As the radically polymerizable group, a known radically polymerizable group can be used, and an acryloyloxy group or a methacryloyloxy group is preferable. It has been known that the acryloyloxy group tends to have a high polymerization rate, and the acryloyloxy group is preferable from the viewpoint of improving productivity, but the methacryloyloxy group can also be used as the polymerizable group.

As the cationically polymerizable group, a known cationically polymerizable group can be used, and examples thereof include an alicyclic ether group, a cyclic acetal group, a cyclic lactone group, a cyclic thioether group, a spiroorthoester group, and a vinyloxy group. Among these, an alicyclic ether group or a vinyloxy group is preferable, and an epoxy group, an oxetanyl group, or a vinyloxy group is more preferable.

Preferable examples of the polymerizable group include polymerizable groups represented by Formulae (P-1) to (P-30).

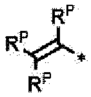 (P-1) 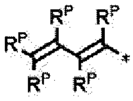 (P-2) 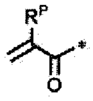 (P-3) 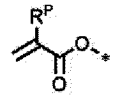 (P-4) 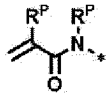 (P-5) 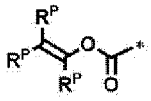 (P-6) 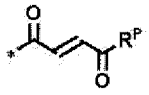 (P-7) 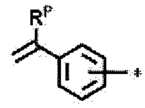 (P-8) 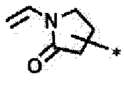 (P-9)

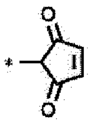 (P-10) 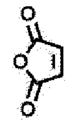 (P-11) 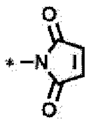 (P-12) 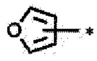 (P-13) 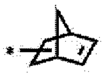 (P-14) 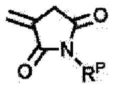 (P-15) 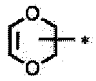 (P-16) 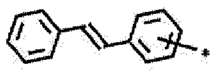 (P-17) 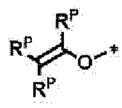 (P-18) 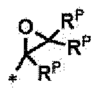 (P-19)

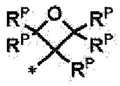 (P-20) 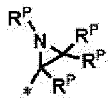 (P-21) 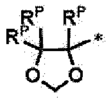 (P-22) 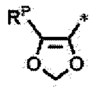 (P-23) 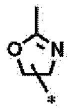 (P-24) 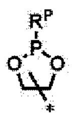 (P-25) 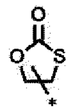 (P-26) 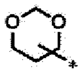 (P-27) 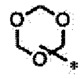 (P-28) 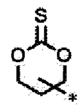 (P-29) 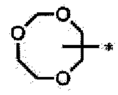 (P-30)

In Formulae (P-1) to (P-30), $R^P$ represents a hydrogen atom, a halogen atom, a linear, branched, or cyclic alkylene group having 1 to 10 carbon atoms, a halogenated alkyl group having 1 to 20 carbon atoms, an alkoxy group having 1 to 20 carbon atoms, an alkenyl group having 1 to 20 carbon atoms, an alkynyl group having 1 to 20 carbon atoms, an aryl group having 1 to 20 carbon atoms, a heterocyclic group (also referred to as a heterocyclic ring group), a cyano group, a hydroxy group, a nitro group, a carboxy group, an aryloxy group, a silyloxy group, a heterocyclic oxy group, an acyloxy group, a carbamoyloxy group, an alkoxycarbonyloxy group, an aryloxycarbonyloxy group, an amino group (including an anilino group), an ammonio group, an acylamino group, an aminocarbonylamino group, an alkoxycarbonylamino group, an aryloxycarbonylamino group, a sulfamoylamino group, an alkyl or arylsulfonylamino group, a mercapto group, an alkylthio group, an arylthio group, a heterocyclic thio group, a sulfamoyl group, a sulfo group, an alkyl or arylsulfinyl group, an alkyl or arylsulfonyl group, an acyl group, an aryloxycarbonyl group, an alkoxycarbonyl group, a carbamoyl group, an aryl or heterocyclic azo group, an imide group, a phosphino group, a phosphinyl group, a phosphinyloxy group, a phosphinylamino group, a phosphono group, a silyl group, a hydrazino group, a ureido group, a boronic acid group ($-B(OH)_2$), a phosphate group ($-OPO(OH)_2$), or a sulfate group ($-OSO_3H$). A plurality of $R^P$s may be the same or different from each other.

Among these, as the radically polymerizable group, the vinyl group represented by Formula (P-1), the butadiene group represented by Formula (P-2), the (meth)acryloyl group represented by Formula (P-4), the (meth)acrylamide group represented by Formula (P-5), the vinyl acetate group represented by Formula (P-6), the fumaric acid ester group represented by Formula (P-7), the styryl group represented by Formula (P-8), the vinylpyrrolidone group represented by Formula (P-9), the maleic anhydride represented by Formula (P-11), or the maleimide group represented by Formula (P-12) is preferable; and as the cationically polymerizable group, the vinyl ether group represented by Formula (P-18), the epoxy group represented by Formula (P-19), or the oxetanyl group represented by Formula (P-20) is preferable.

In Formula (A-1), examples of the divalent linking group represented by one aspect of V1, V2, X1, X2, and La include -O-, $-(CH_2)_g-$, $-(CF_2)_g-$, $-Si(CH_3)_2-$, $-(Si(CH_3)_2O)_g-$, $-(OSi(CH_3)_2)_g-$ (g represents an integer of 1 to 10), -N(Z)-, -C(Z)=C(Z')-, -C(Z)=N-, -N=C(Z)-, $-C(Z)_2-C(Z')_2-$, -C(O)-, -OC(O)-, -C(O)O-, -O-C(O)O-, -N(Z)C(O)-, -C(O)N(Z)-, -C(Z)=C(Z')-C(O)O-, -O-C(O)-C(Z)=C(Z')-, -C(Z)=N-, -N=C(Z)-, -C(Z)=C(Z')-C(O)N(Z")-, -N(Z")-C(O)-C(Z)=C(Z')-, -C(Z)=C(Z')-C(O)-S-, -S-C(O)-C(Z)=C(Z')-, -C(Z)=N-N=C(Z')- (here, Z, Z', and Z" independently represent hydrogen, an alkyl group having 1 to 4 carbon atoms, a cycloalkyl group, an aryl group, a cyano group, or a halogen atom), -C≡C-, -N=N-, -S-, -S(O)-, -S(O)(O)-, -(O)S(O)O-, -O(O)S(O)O-, -SC(O)-, and -C(O)S-. V1, V2, X1, X2, and La may be a group obtained by combining two or more of the above groups.

In Formula (A-1), examples of the divalent spacer group represented by SP1 and SP2 include a linear, branched, or cyclic alkylene group having 1 to 50 carbon atoms and a heterocyclic group having 1 to 20 carbon atoms.

The carbon atoms of the alkylene group and the heterocyclic group may be substituted with -O-, $-Si(CH_3)_2-$, $-(Si(CH_3)_{20})_g-$, $-(OSi(CH_3)_2)_g-$ (g represents an integer of 1 to 10), -N(Z)-, -C(Z)=C(Z')-, -C(Z)=N-, -N=C(Z)-, $-C(Z)_2-C(Z')_2-$, -C(O)-, -OC(O)-, -C(O)O-, -O-C(O)O-, - N(Z)C(O)-, -C(O)N(Z)-, -C(Z)=C(Z')-C(O)O-, -O-C(O)-C(Z)=C(Z')-, -C(Z)=N-, -N=C(Z)-, - C(Z)=C(Z')-C(O)N(Z")-, -N(Z")-C(O)-C(Z)=C(Z')-, -C(Z)=C(Z')-C(O)-S-, -S-C(O)-C(Z)=C(Z')-, -C(Z)=N-N=C(Z')- (here, Z, Z', and Z" each independently represent hydrogen, an alkyl group having 1 to 4 carbon atoms, a cycloalkyl group, an aryl group, a cyano group, or a halogen atom), -C≡C-, -N=N-, -S-, -C(S)-, -S(O)-, $-SO_2-$, -(O)S(O)O-, -O(O)S(O)O-, -SC(O)-, -C(O)S-, or a group obtained by combining two or more of these groups.

The hydrogen atom of the above-described alkylene group or the hydrogen atom of the heterocyclic group may be substituted with a halogen atom, a cyano group, $-Z^H$, -OH, $-OZ^H$, - COOH, $-C(O)Z^H$, $-C(O)OZ^H$, $-OC(O)Z^H$, $-OC(O)OZ^H$, $-NZ^HZ^{H'}$, $-NZ^HC(O)Z^{H'}$, - $NZ^HC(O)OZ^{H'}$, $-C(O)NZ^HZ^{H'}$, $-OC(O)NZ^HZ^{H'}$, $-NZ^HC(O)NZ^{H'}OZ^{H''}$, -SH, $-SZ^H$, $-C(S)Z^H$, - $C(O)SZ^H$, or $-SC(O)Z^H$. Here, $Z^H$, $Z^{H'}$, and Z" each independently represent an alkyl group having 1 to 10 carbon atoms, a halogenated alkyl group, or -L-Q (L represents a single bond or a divalent linking group, specific examples of the divalent linking group are the same as those for V1 described above, Q represents a crosslinkable group, examples of the crosslinkable group include the polymerizable group represented by Q1 or Q2. Among these, polymerizable groups represented by Formulae (P-1) to (P-30) are preferable).

In Formula (A-1), MA represents an aromatic ring, an aliphatic ring, or a heterocyclic ring, which may have a substituent and preferably a 4- to 15-membered ring. MA may represent a monocyclic ring or a fused ring, and a plurality of MA's may be the same or different from each other.

Examples of the aromatic ring represented by MA include a phenylene group, a naphthylene group, a fluorene-diyl group, an anthracene-diyl group, and a tetracene-diyl group. From the viewpoint of design diversity of the mesogenic skeleton and the availability of raw materials, a phenylene group or a naphthylene group is preferable.

Specific examples of the aliphatic ring represented by MA include a cyclopentylene group and a cyclohexylene group, and carbon atoms thereof may be substituted with -O-, - $Si(CH_3)_2$-, -N(Z)-, -C(O)-, (Z independently represents hydrogen, an alkyl group having 1 to 4 carbon atoms, a cycloalkyl group, an aryl group, a cyano group, or a halogen atom), -S-, -C(S)-, -S(O)-, $-SO_2$-, or a group obtained by combining two or more of these groups.

Examples of atoms other than carbon constituting the heterocyclic ring represented by MA include a nitrogen atom, a sulfur atom, and an oxygen atom. In a case where the heterocyclic ring has a plurality of atoms forming the ring other than carbon, the atoms may be the same as or different from each other. Specific examples of the heterocyclic ring include a pyridylene group (pyridine-diyl group), a pyridazine-diyl group, an imidazole-diyl group, thienylene (thiophene-diyl group), a quinolylene group (quinoline-diyl group), an isoquinolylene group (isoquinoline-diyl group), an oxazole-diyl group, a thiazole-diyl group, an oxadiazole-diyl group, a benzothiazole-diyl group, a benzothiadiazole-diyl group, a phthalimido-diyl group, a thienothiazole-diyl group, a thiazolothiazole-diyl group, a thienothiophene-diyl group, a thienooxazole-diyl group, and the following structures (II-1) to (II-4).

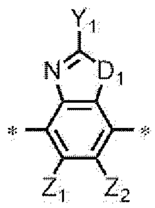
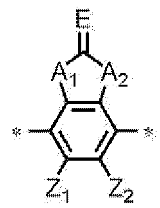
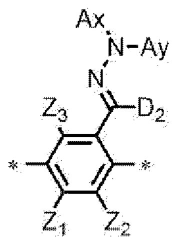
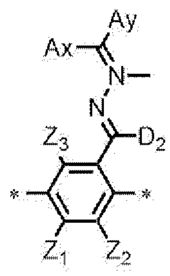

(II-1) (II-2) (II-3) (II-4)

In Formulae (II-1) to (II-4), $D_1$ represents -S-, -O-, or $NR^{11}$-, and $R^{11}$ represents a hydrogen atom or an alkyl group having 1 to 6 carbon atoms.

$Y_1$ represents an aromatic hydrocarbon group having 6 to 12 carbon atoms or an aromatic heterocyclic group having 3 to 12 carbon atoms.

$Z_1$, $Z_2$, and $Z_3$ each independently represent a hydrogen atom, an aliphatic hydrocarbon group having 1 to 20 carbon atoms, an alicyclic hydrocarbon group having 3 to 20 carbon atoms, a monovalent aromatic hydrocarbon group having 6 to 20 carbon atoms, a halogen atom, a cyano group, a nitro group, $-NR^{12}R^{13}$, or $SR^{12}$. Here, $Z^1$ and $Z^2$ may be bonded to each other to form an aromatic ring or an aromatic heterocyclic ring, and $R^{12}$ and $R^{13}$ each independently represent a hydrogen atom or an alkyl group having 1 to 6 carbon atoms.

$A_1$ and $A_2$ each independently represent a group selected from the group consisting of -O-, $-NR^{21}$- ($R^{21}$ represents a hydrogen atom or a substituent), -S-, and -CO-.

E represents a non-metal atom of Group 14 to Group 16, to which a hydrogen atom or a substituent may be bonded.

Ax represents an organic group which has 2 to 30 carbon atoms and has at least one aromatic ring selected from the group consisting of an aromatic hydrocarbon ring and an aromatic heterocyclic ring; Ay represents a hydrogen atom, an alkyl group which has 1 to 6 carbon atoms and may have a substituent, or an organic group which has 2 to 30 carbon atoms and has at least one aromatic ring selected from the group consisting of an aromatic hydrocarbon ring and an aromatic heterocyclic ring; the aromatic ring included in Ax and Ay may have a substituent; and Ax and Ay may be bonded to each other to form a ring.

$D_2$ represents a hydrogen atom or an alkyl group having 1 to 6 carbon atoms, which may have a substituent.

In Formula (II-2), in a case where $Y_1$ represents an aromatic hydrocarbon group having 6 to 12 carbon atoms, the aromatic hydrocarbon group may be monocyclic or polycyclic. In a case where $Y_1$ represents an aromatic heterocyclic group having 3 to 12 carbon atoms, the aromatic heterocyclic group may be monocyclic or polycyclic.

In Formula (II-2), in a case where $A_1$ and $A_2$ represent $-NR^{21}-$, the substituent as $R^{21}$ can refer to, for example, the description in paragraphs 0035 to 0045 of JP2008-107767A, and the content thereof is incorporated in the present specification.

In Formula (II-2), in a case where X represents a non-metal atom of Group 14 to Group 16, to which a substituent may be bonded, =O, =S, =NR', or =C(R')R' is preferable. R' represents a substituent. The substituent can refer to, for example, the description in paragraphs [0035] to [0045] of JP2008-107767A, and a nitrogen atom is preferable.

Examples of the substituent that an aromatic ring, an aliphatic ring, or a heterocyclic ring as MAin Formula (A-1) may have include a halogen atom, an alkyl group having 1 to 20 carbon atoms, a halogenated alkyl group having 1 to 20 carbon atoms, a cycloalkyl group having 1 to 20 carbon atoms, an alkoxy group having 1 to 20 carbon atoms, an alkenyl group having 1 to 20 carbon atoms, an alkynyl group having 1 to 20 carbon atoms, an aryl group having 1 to 20 carbon atoms, a heterocyclic group (also referred to as heterocyclic ring group), a cyano group, a hydroxy group, a nitro group, a carboxy group, an aryloxy group, a silyloxy group, a heterocyclic oxy group, an acyloxy group, a carbamoyloxy group, an alkoxycarbonyloxy group, an aryloxycarbonyloxy group, an amino group (including an anilino group), an ammonio group, an acylamino group, an aminocarbonylamino group, an alkoxycarbonylamino group, an aryloxycarbonylamino group, a sulfamoylamino group, an alkyl or arylsulfonylamino group, a mercapto group, an alkylthio group, an arylthio group, a heterocyclic thio group, a sulfamoyl group, a sulfo group, an alkyl or arylsulfinyl group, an alkyl or arylsulfonyl group, an acyl group, an aryloxycarbonyl group, an alkoxycarbonyl group, a carbamoyl group, an aryl or heterocyclic azo group, an imide group, a phosphino group, a phosphinyl group, a phosphinyloxy group, a phosphinylamino group, a phosphono group, a silyl group, a hydrazino group, a ureido group, a boronic acid group ($-B(OH)_2$), a phosphate group ($-OPO(OH)_2$), a sulfate group ($-OSO_3H$), and other known substituents.

Details of the substituent are described in paragraph [0023] of JP2007-234651A.

In Formula (A-1), na represents an integer of 2 to 10 and more preferably an integer of 2 to 8.

Examples of the smectic liquid crystal compound include compounds described in paragraphs [0033] to [0039] of JP2008-19240A, paragraphs [0037] to [0041] of JP2008-214269A, and paragraphs [0033] to [0040] of JP2006-215437A, and structures shown below, but the smectic liquid crystal compound is not limited thereto.

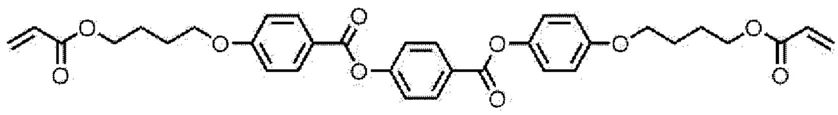

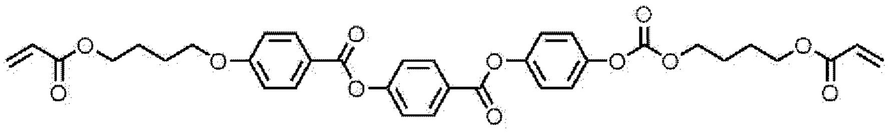

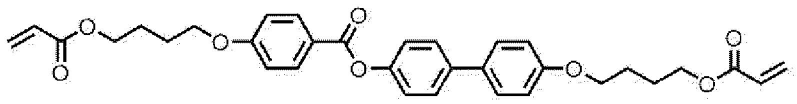

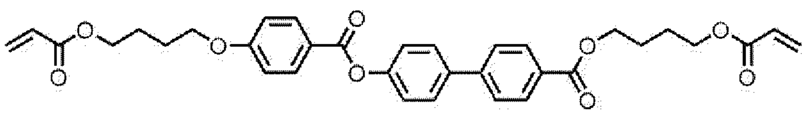

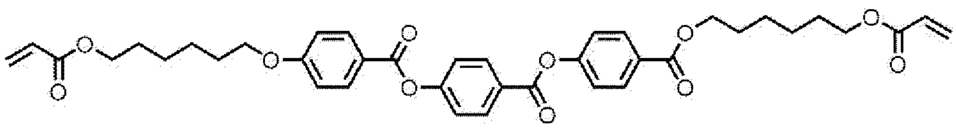

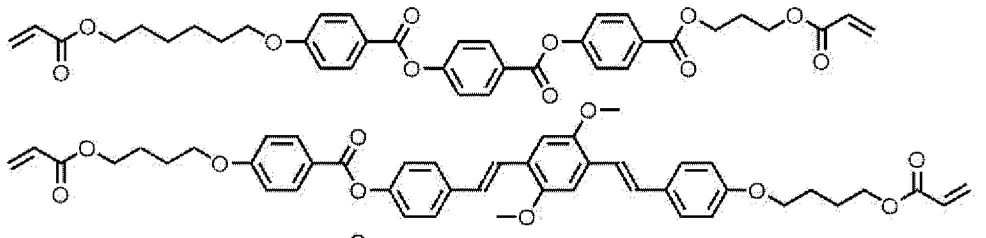

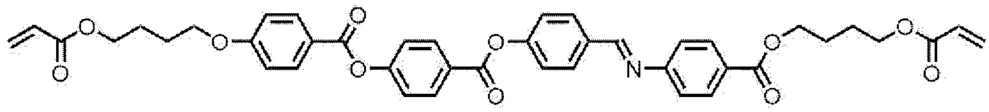

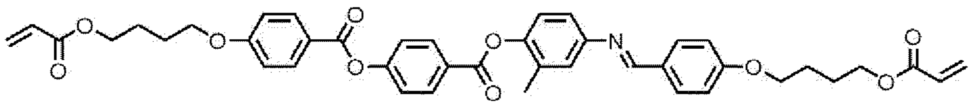

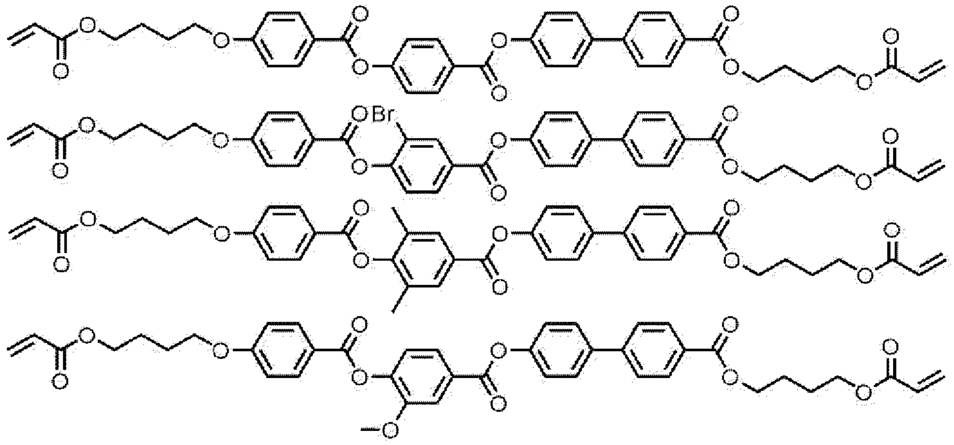

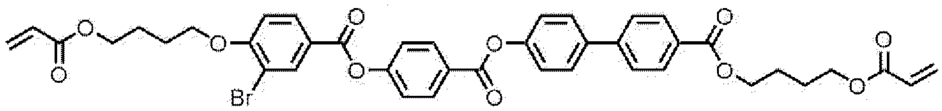

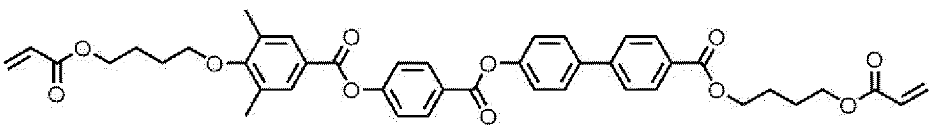

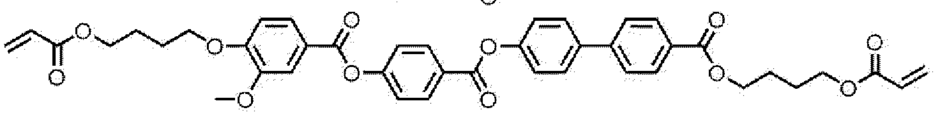

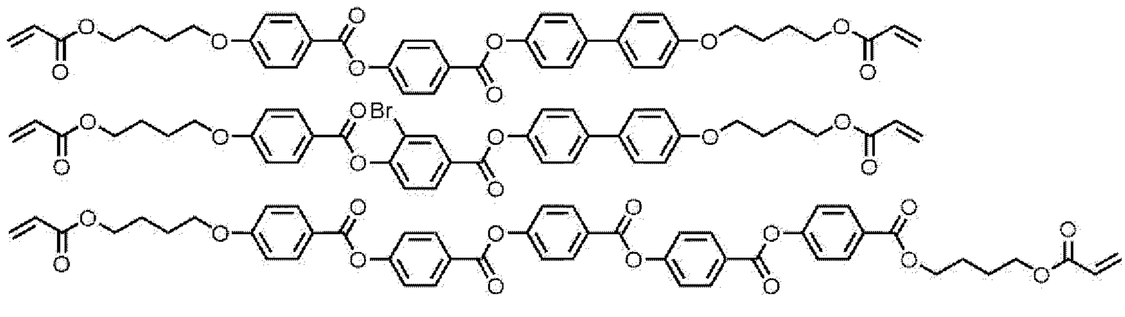

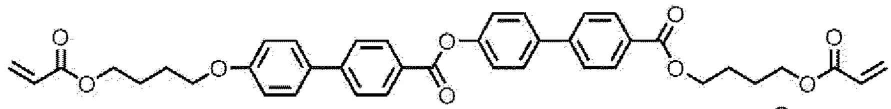

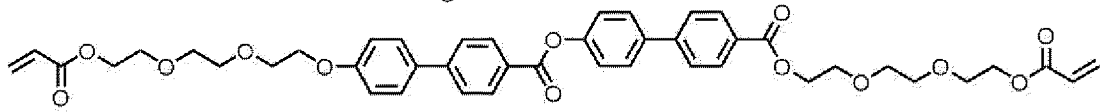

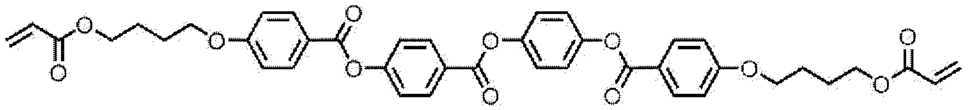

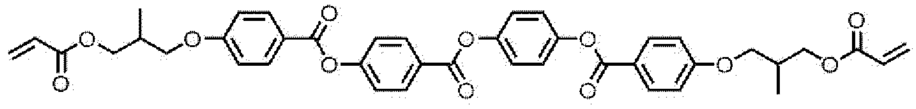

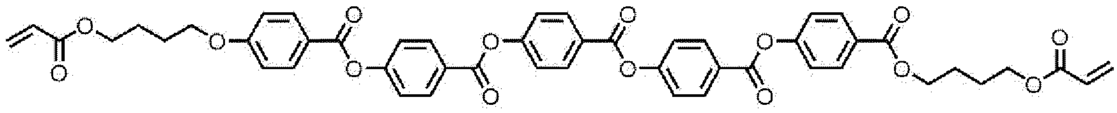

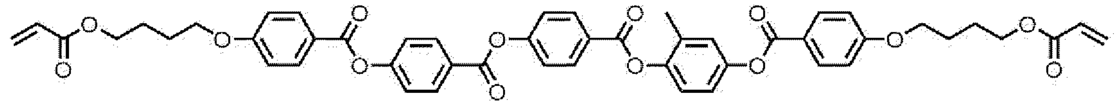

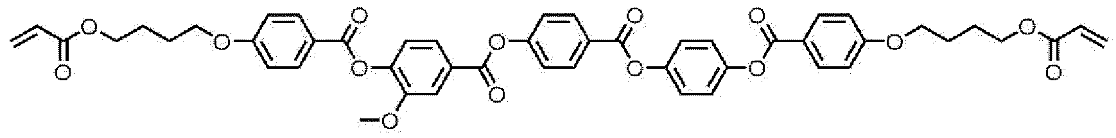

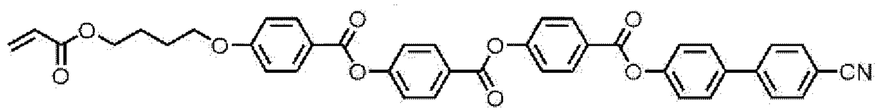

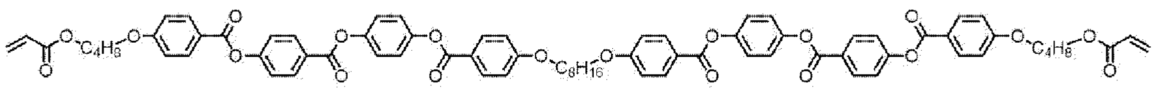

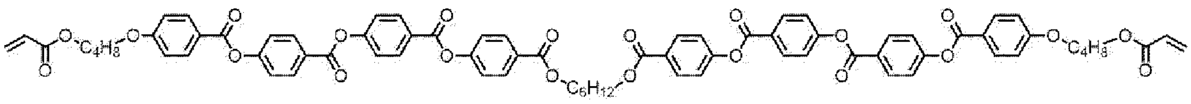

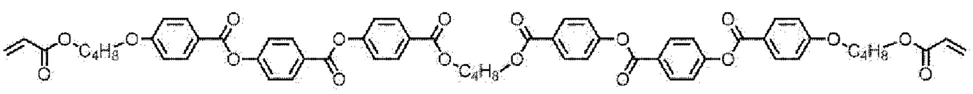

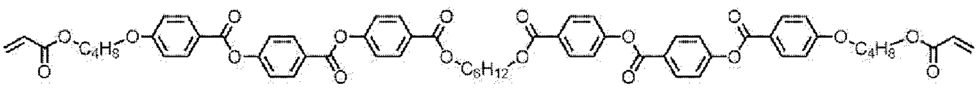

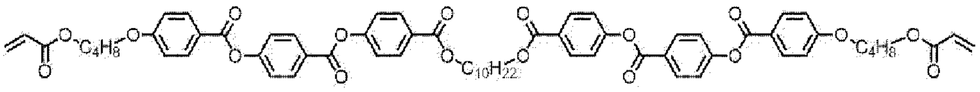

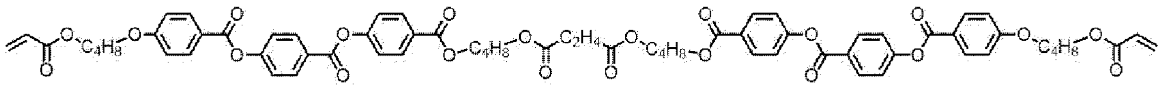

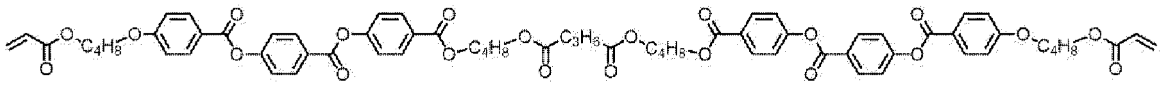

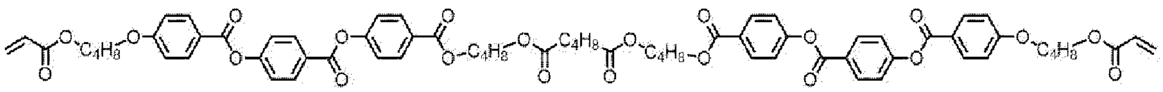

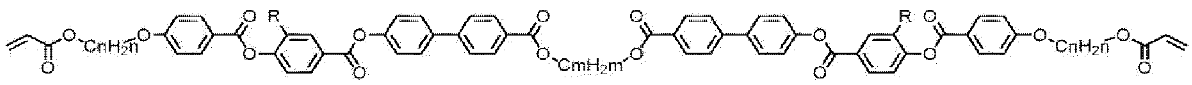

| n | m | R |
|---|---|---|
| 4 | 4 | H |
| 4 | 6 | H |
| 4 | 10 | H |
| 6 | 10 | H |
| 6 | 12 | H |
| 4 | 8 | OCH3 |
| 4 | 12 | OCH3 |
| 6 | 10 | Br |
| 6 | 12 | Br |
| 8 | 12 | OCH3 |

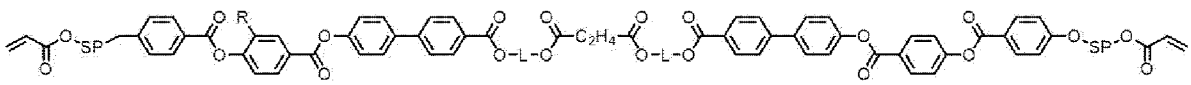

| SP | L | R |
|---|---|---|
| −(CH2)4− | −(CH2)3− | H |
| −(CH2)4− | −(CH2)3− | Br |
| −(CH2)4− | −(CH2)3− | OCH3 |
| −CH2CH(CH3)CH2− | −(CH2)3− | H |
| −(CH2CH2O)2CH2CH3− | −(CH2)3− | H |
| −(CH2CH2O)2CH2CH3− | −(CH2CH2O)2CH2CH3− | H |

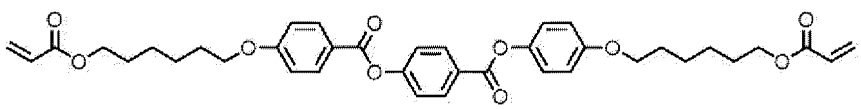

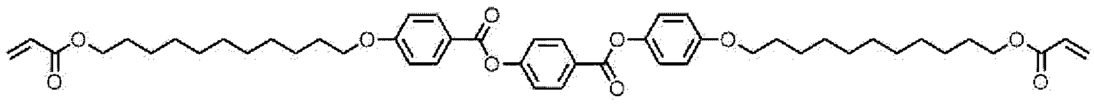

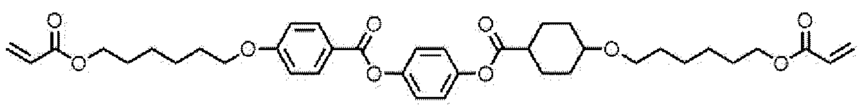

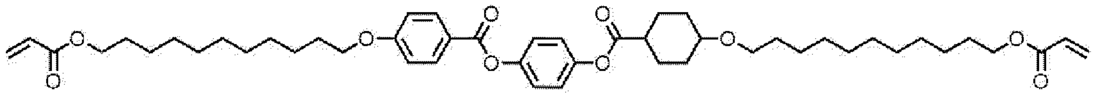

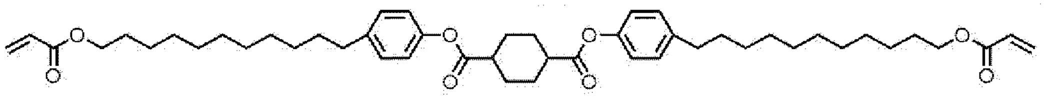

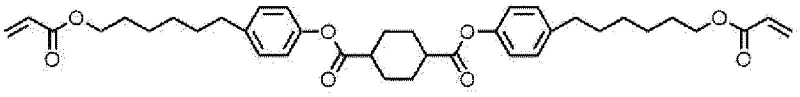

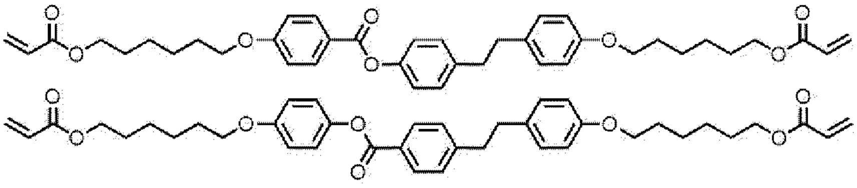

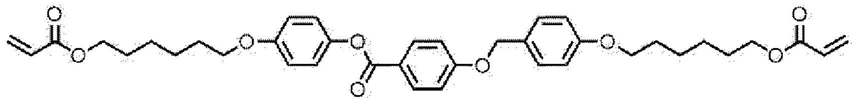

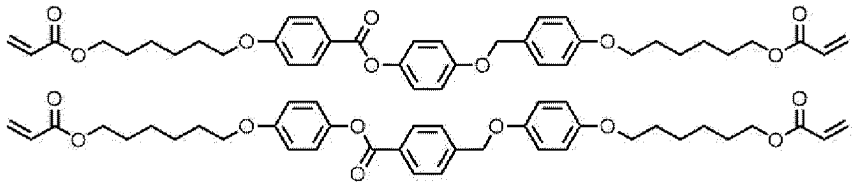

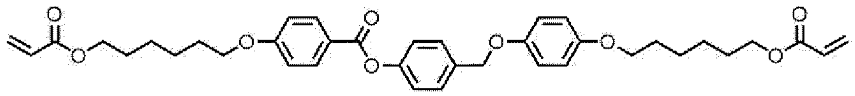

A content of the smectic liquid crystal compound is preferably 50% to 99% by mass and more preferably 60% to 95% by mass with respect to the total solid content mass of the liquid crystal composition.

The content of the liquid crystal compound is not particularly limited, but is preferably 50% to 99% by mass and more preferably 75% to 90% by mass with respect to the total mass of the light absorption anisotropic layer.

<Vertical Alignment Agent>

In the present invention, from the reason that deterioration in surface state due to alignment disorder can be suppressed, the light absorption anisotropic layer (particularly, the specific light absorption anisotropic layer) preferably contains a fluorine-based vertical alignment agent having a boronic acid group.

Examples of the fluorine-based vertical alignment agent having a boronic acid group include a copolymer having a repeating unit A represented by Formula (A-1) and a repeating unit B represented by Formula (B-1).

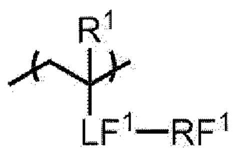

(A-1)

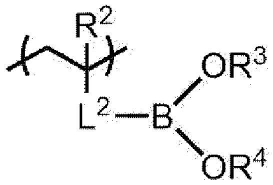 (B-1)

In Formula (A-1),

$R^1$ represents a hydrogen atom or an alkyl group having 1 to 20 carbon atoms,
$LF^1$ represents a single bond or a divalent linking group, and
$RF^1$ represents a group containing a fluorine atom.

In addition, in Formula (B-1),

$R^2$ represents a hydrogen atom or an alkyl group having 1 to 20 carbon atoms.
$L^2$ represents a single bond or a divalent linking group selected from the group consisting of -O-, -S-, -COO-, -OCO-, $-CONR^{L1}-$, $-NR^{L1}COO-$ $-CR^{L1}N-$, a substituted or unsubstituted divalent aliphatic group, a substituted or unsubstituted divalent aromatic group, and a combination thereof, and $R^{L1}$ represents a hydrogen atom or an alkyl group having 1 to 20 carbon atoms.
$R^3$ and $R^4$ each independently represent a hydrogen atom, a substituted or unsubstituted aliphatic hydrocarbon group, a substituted or unsubstituted aryl group, or a substituted or unsubstituted heteroaryl group, and $R^3$ and $R^4$ may be linked to each other through a linking group consisting of an alkylene linking group, an arylene linking group, or a combination of these groups.

In Formula (A-1), as described above, $R^1$ represents a hydrogen atom or an alkyl group having 1 to 20 carbon atoms, and among these, the hydrogen atom or an alkyl group having 1 to 10 carbon atoms is preferable, the hydrogen atom or an alkyl group having 1 to 4 carbon atoms is more preferable, and the hydrogen atom or a methyl group is still more preferable.

In addition, in Formula (A-1), as described above, $LF^1$ represents a single bond or a divalent linking group, and among these, a divalent linking group selected from the group consisting of -O-, -COO-, -OCO-, a divalent aliphatic group, and a combination thereof is preferable. -COO- represents that a carbon to which $R^1$ is bonded is bonded to C=O and $RF^1$ is bonded to O, and -OCO- represents that a carbon to which $R^1$ is bonded is bonded to O and $RF^1$ is bonded to C=O.

Here, examples of the divalent aliphatic group include a divalent aliphatic chain group and a divalent aliphatic cyclic group. As the divalent aliphatic chain group, an alkylene group having 1 to 20 carbon atoms is preferable, and an alkylene group having 1 to 10 carbon atoms is more preferable. As the divalent aliphatic cyclic group, a cycloalkylene group having 3 to 20 carbon atoms is preferable, and a cycloalkylene group having 3 to 15 carbon atoms is more preferable.

Among those, as $LF^1$, -COO- or -OCO- is preferable, and -COO- is more preferable.

In addition, in Formula (A-1), as described above, $RF^1$ represents a group containing a fluorine atom, and among these, an alkyl group having 1 to 20 carbon atoms (hereinafter, also referred to as a "fluoroalkyl group") in which at least one hydrogen atom is substituted with a fluorine atom is preferable, a fluoroalkyl group having 1 to 18 carbon atoms is more preferable, and a fluoroalkyl group having 2 to 15 carbon atoms is still more preferable.

In addition, the fluoroalkyl group preferably includes at least one $-CF_3$ group.

In addition, the number of fluorine atoms is preferably 1 to 25, more preferably 3 to 21, and most preferably 5 to 21.

In the present invention, the repeating unit represented by Formula (A-1) is preferably a repeating unit represented by Formula (A-1-1).

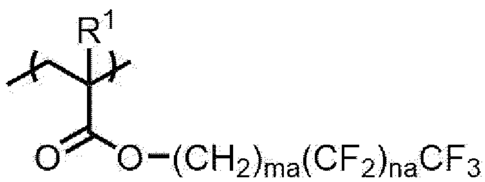 (A-1-1)

In Formula (A-1-1), $R^1$ represents a hydrogen atom or an alkyl group having 1 to 20 carbon atoms, as in $R^1$ in Formula (A-1), and a suitable aspect thereof is also the same.

In addition, in Formula (A-1-1), ma and na each independently represent an integer of 0 to 19. Among these, from the viewpoint of obtaining raw materials, ma is preferably an integer of 1 to 8 and more preferably an integer of 1 to 5. In

addition, na is preferably an integer of 1 to 15, more preferably an integer of 1 to 12, still more preferably an integer of 2 to 10, and most preferably an integer of 5 to 7. It should be noted that ma and na represent an integer of 0 to 19 in total.

Specific examples of the monomer forming the repeating unit represented by Formula (A-1) or (A-1-1) include 2,2,2-trifluoroethyl (meth)acrylate, 2,2,3,3,3-pentafluoropropyl (meth)acrylate, 2-(perfluorobutyl)ethyl (meth)acrylate, 2-(perfluorohexyl)ethyl (meth)acrylate, 2-(perfluorooctyl)ethyl (meth)acrylate, 2-(perfluorodecyl)ethyl (meth)acrylate, 2-(perfluoro-3-methylbutyl)ethyl (meth)acrylate, 2-(perfluoro-5-methylhexyl)ethyl (meth)acrylate, 2-(perfluoro-7-methyloctyl)ethyl (meth)acrylate, 3-perfluorobutyl-2-hydroxypropyl (meth)acrylate, 3-perfluorohexyl-2-hydroxypropyl (meth) acrylate, 3-perfluorooctyl-2-hydroxypropyl (meth)acrylate, 3-(perfluoro-3-methylbutyl)-2-hydroxypropyl (meth)acrylate, 3-(perfluoro-5-methylhexyl)-2-hydroxypropyl (meth)acrylate, and 3-(perfluoro-7-methyloctyl)-2-hydroxypropyl (meth)acrylate.

In Formula (B-1), as described above, $R^2$'s each independently represent a hydrogen atom or an alkyl group having 1 to 20 carbon atoms, and among these, a hydrogen atom or an alkyl group having 1 to 10 carbon atoms is preferable, a hydrogen atom or an alkyl group having 1 to 4 carbon atoms is more preferable, and a hydrogen atom or a methyl group is still more preferable.

In addition, in Formula (B-1), as described above, $L^2$ represents a single bond or a divalent linking group selected from the group consisting of -O-, -S-, -COO-, -OCO-, -CONR$^{L1}$-, -NR$^{L1}$COO-, -CR$^{L1}$N-, a substituted or unsubstituted divalent aliphatic group, a substituted or unsubstituted divalent aromatic group, and a combination thereof, and $R^{L1}$ represents a hydrogen atom or an alkyl group having 1 to 20 carbon atoms.

Examples of the substituted or unsubstituted divalent aliphatic group represented by one aspect of $L^2$ include an alkylene group having 1 to 20 carbon atoms, which may have a substituent, and a cycloalkylene group having 3 to 20 carbon atoms, which may have a substituent (for example, a cyclohexylene group). Among these, an alkylene group having 1 to 15 carbon atoms is preferable, an alkylene group having 1 to 8 carbon atoms is more preferable, and a methylene group, an ethylene group, a propylene group, or a butylene group is still more preferable.

In addition, examples of the substituted or unsubstituted divalent aromatic group represented by one aspect of $L^2$ include a divalent aromatic hydrocarbon group which may have a substituent and a divalent aromatic heterocyclic group which may have a substituent. Examples of the divalent aromatic hydrocarbon group include a group obtained by removing one hydrogen atom from each of two carbon atoms constituting a ring structure of an aromatic hydrocarbon ring such as a benzene ring, a naphthalene ring, an anthracene ring, a triphenylene ring, or a fluorene ring. Among these, a phenylene group or a naphthylene group obtained by removing one hydrogen atom from each of two carbon atoms constituting a ring structure of a benzene ring or a naphthalene ring is preferable. On the other hand, examples of the divalent aromatic heterocyclic group include groups obtained by removing one hydrogen atom from each of two carbon atoms constituting a ring structure of an aromatic heterocyclic ring such as a furan ring, a pyrrole ring, a thiophene ring, a pyridine ring, a thiazole ring, a benzothiazole ring, an oxadiazole ring, a thiazolothiazole ring, and a phenanthroline ring.

Examples of the substituent which may be contained in the divalent aliphatic group or the divalent aromatic group include an alkyl group, an alkoxy group, an alkylcarbonyl group, an alkoxycarbonyl group, an alkylcarbonyloxy group, an alkylamino group, a dialkylamino group, an alkylamide group, an alkenyl group, an alkynyl group, a halogen atom, a cyano group, a nitro group, an alkylthiol group, and an N-alkylcarbamate group.

In addition, the alkyl group having 1 to 20 carbon atoms, represented by one aspect of $R^{L1}$ described above, is preferably an alkyl group having 1 to 6 carbon atoms, and specific examples thereof include a methyl group, an ethyl group, a propyl group, an isopropyl group, an n-butyl group, an isobutyl group, a sec-butyl group, a tert-butyl group, an n-pentyl group, and an n-hexyl group.

In addition, in Formula (B-1), as described above, $R^3$ and $R^4$ each independently represent a hydrogen atom, a substituted or unsubstituted aliphatic hydrocarbon group, a substituted or unsubstituted aryl group, or a substituted or unsubstituted heteroaryl group, and $R^3$ and $R^4$ may be linked to each other through an alkylene linking group, an arylene linking group, or a linking group consisting of a combination thereof.

Examples of the substituted or unsubstituted aliphatic hydrocarbon group represented by one aspect of $R^3$ and $R^4$ include an alkyl group, an alkenyl group, or an alkynyl group, which may have a substituent.

Specific examples of the alkyl group include linear, branched, and cyclic alkyl groups such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a tert-butyl group, an isopentyl group, a neopentyl group, a 1-methylbutyl group, an isohexyl group, a 2-methylhexyl group, a cyclopentyl group, a cyclohexyl group, a 1-adamantyl group, and a 2-norbornyl group.

Specific examples of the alkenyl group include linear, branched, and cyclic alkenyl groups such as a vinyl group, a 1-propenyl group, a 1-butenyl group, a 1-methyl-1-propenyl group, a 1-cyclopentenyl group, and a 1-cyclohexenyl group.

Specific examples of the alkynyl group include an ethynyl group, a 1-propynyl group, a 1-butynyl group, and a 1-octynyl group.

In addition, examples of the substituted or unsubstituted aryl group represented by one aspect of $R^3$ and $R^4$

include those in which 1 to 4 benzene rings form a fused ring and those in which a benzene ring and an unsaturated five-membered ring form a fused ring, and specific examples thereof include a phenyl group, a naphthyl group, an anthryl group, a phenanthryl group, an indenyl group, an acenaphthenyl group, a fluorenyl group, and a pyrenyl group.

Moreover, examples of the substituted or unsubstituted heteroaryl group represented by one aspect of $R^3$ and $R^4$ include a heteroaryl group obtained by removing one hydrogen atom on a heteroaromatic ring including one or more heteroatoms selected from the group consisting of a nitrogen atom, an oxygen atom, and a sulfur atom.

Specific examples of the heteroaromatic ring including one or more heteroatoms selected from the group consisting of a nitrogen atom, an oxygen atom, and a sulfur atom include pyrrole, furan, thiophene, pyrazole, imidazole, triazole, oxazole, isoxazole, oxadiazole, thiazole, thiadiazole, indole, carbazole, benzofuran, dibenzofuran, thianaphthene, dibenzothiophene, indazole benzimidazole, anthranil, benzisoxazole, benzoxazole, benzothiazole, purine, pyridine, pyridazine, pyrimidine, pyrazine, triazine, quinoline, acridine, isoquinoline, phthalazine, quinazoline, quinoxaline, naphthyridine, phenanthroline, and pteridine.

Examples of the substituent which may be included in $R^3$ and $R^4$ include an alkyl group, an alkoxy group, an alkylcarbonyl group, an alkoxycarbonyl group, an alkylcarbonyloxy group, an alkylamino group, a dialkylamino group, an alkylamide group, an alkenyl group, an alkynyl group, a halogen atom, a cyano group, a nitro group, an alkylthiol group, and an N-alkyl carbamate group.

Specific examples of the monomer forming the repeating unit represented by Formula (B-1) include monomers represented by Formulae II-1 to II-12.

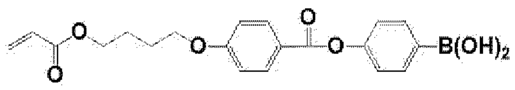

II-1

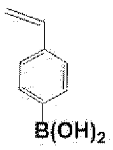

II-2

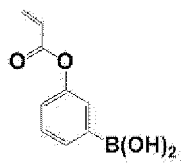

II-3

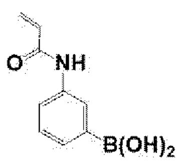

II-4

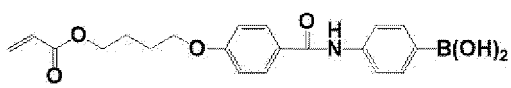

II-5

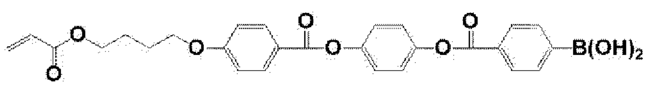

II-6

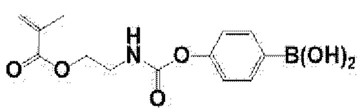

II-7

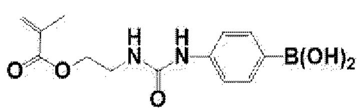

II-8

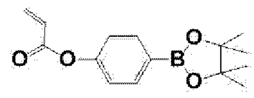

II-9

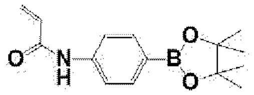

II-10

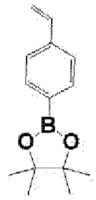

II-11

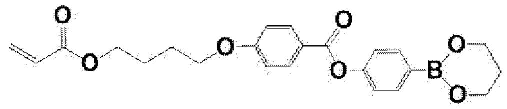

II-12

In a case where the light absorption anisotropic layer contains a vertical alignment agent, the content of the vertical alignment agent is preferably 0.1% to 400% by mass, and more preferably 0.5% to 350% by mass with respect to the total mass of the liquid crystal compound.
The vertical alignment agents may be used alone or in combination of two or more kinds thereof. In a case where two or more kinds of vertical alignment agents are used, the total amount thereof is preferably within the above range.

<Composition for Forming Light Absorption Anisotropic Layer>

The light absorption anisotropic layer is preferably formed of a composition for forming a light absorption anisotropic layer containing a dichroic substance and a liquid crystal compound.
The composition for forming a light absorption anisotropic layer preferably contains a solvent and the like to be described later in addition to the dichroic substance and the liquid crystal compound, and may further contain other components described above.
Examples of the dichroic substance contained in the composition for forming a light absorption anisotropic layer include a dichroic substance which can be contained in the light absorption anisotropic layer.
The content of the dichroic substance with respect to the total solid content mass of the composition for forming a light absorption anisotropic layer is preferably the same as the content of the dichroic substance with respect to the total mass of the light absorption anisotropic layer.
Here, the "total solid content in the composition for forming a light absorption anisotropic layer" denotes components excluding the solvent, and specific examples of the solid content include the dichroic substance, the liquid crystal compound, and the above-described other components.
The liquid crystal compound and other components which can be contained in the composition for forming a light absorption anisotropic layer are respectively the same as the liquid crystal compound and other components which can be contained in the light absorption anisotropic layer.
It is preferable that the content of the liquid crystal compound and the content of other components with respect to the total solid content mass of the composition for forming a light absorption anisotropic layer be respectively the same as the content of the liquid crystal compound and the content of other components with respect to the total mass of the light absorption anisotropic layer.
From the viewpoint of workability, the composition for forming a light absorption anisotropic layer preferably contains a solvent.
Examples of the solvent include organic solvents such as ketones, ethers, aliphatic hydrocarbons, alicyclic hydrocarbons, aromatic hydrocarbons, carbon halides, esters, alcohols, cellosolves, cellosolve acetates, sulfoxides, amides, and heterocyclic compounds, and water.
These solvents may be used alone or in combination of two or more kinds thereof.
Among these solvents, organic solvents are preferable, and carbon halides or ketones are more preferable.
In a case where the composition for forming a light absorption anisotropic layer contains a solvent, the content of the solvent is preferably 80% to 99% by mass, more preferably 83% to 97% by mass, and even more preferably 85% to

95% by mass with respect to the total mass of the composition for forming a light absorption anisotropic layer.

The composition for forming a light absorption anisotropic layer may contain a polymerization initiator.

The polymerization initiator is not particularly limited, but a photosensitive compound, that is, a photopolymerization initiator is preferable.

Commercially available products can also be used as such a photopolymerization initiator, and examples thereof include IRGACURE 184, IRGACURE 907, IRGACURE 369, IRGACURE 651, IRGACURE 819, IRGACURE OXE-01, and IRGACURE OXE-02, manufactured by BASF SE.

The polymerization initiators may be used alone or in combination of two or more kinds thereof.

In a case where the composition for forming a light absorption anisotropic layer contains a polymerization initiator, the content of the polymerization initiator is preferably 0.01% to 30% by mass, and more preferably 0.1% to 15% by mass with respect to the total solid content of the composition for forming a light absorption anisotropic layer.

<Method of Producing Light Absorption Anisotropic Layer>

The method of producing the light absorption anisotropic layer is not particularly limited, but a method including a step of coating an alignment film with the composition for forming a light absorption anisotropic layer containing a dichroic substance and a liquid crystal compound to form a coating film (hereinafter, also referred to as "coating film forming step") and a step of aligning a liquid crystal component contained in the coating film (hereinafter, also referred to as "aligning step") in this order (hereinafter, also referred to as "present production method") is preferable from the viewpoint of a further increase of the alignment degree of the dichroic substance.

Further, the liquid crystal component is a component containing not only the liquid crystal compound described above but also a dichroic substance having liquid crystallinity.

Hereinafter, the respective steps will be described.

The coating film forming step is a step of coating an alignment film with the composition for forming a light absorption anisotropic layer to form a coating film.

The alignment film is easily coated with the composition for forming a light absorption anisotropic layer by using the composition for forming a light absorption anisotropic layer which contains the above-described solvent or using a liquid-like material such as a melt obtained by heating the composition for forming a light absorption anisotropic layer.

Examples of the coating method using the composition for forming a light absorption anisotropic layer include known methods such as a roll coating method, a gravure printing method, a spin coating method, a wire bar coating method, an extrusion coating method, a direct gravure coating method, a reverse gravure coating method, a die-coating method, a spraying method, and an ink jet method.

The alignment film may be any film as long as it is a film in which the liquid crystal component which can be contained in the composition for forming a light absorption anisotropic layer is aligned.

The alignment film can be provided by methods such as a rubbing treatment performed on a film surface of an organic compound (preferably a polymer), oblique vapor deposition of an inorganic compound, formation of a layer having microgrooves, or accumulation of an organic compound (such as ω-tricosanoic acid, dioctadecyl methylammonium chloride, or methyl stearylate) using a Langmuir-Blodgett method (LB film). Furthermore, there have been known alignment films having an aligning function imparted thereto by applying an electrical field, applying a magnetic field, or light irradiation. Among these, in the present invention, an alignment film formed by performing a rubbing treatment is preferable from the viewpoint of easily controlling the pretilt angle of the alignment film, and a photo-alignment film formed by irradiation with light is also preferable from the viewpoint of the uniformity of alignment.

As the photo-alignment film, a photo-alignment film containing an azobenzene coloring agent, polyvinyl cinnamate, or the like is used.

The dichroic substance in the light absorption anisotropic layer can be aligned by irradiating a photo-alignment layer with ultraviolet rays in an oblique direction at an angle to the normal direction of the photo-alignment layer, generating anisotropy with an inclination with respect to the normal direction of the photo-alignment layer, and aligning the light absorption anisotropic layer thereon.

In addition, a liquid crystal layer in which the liquid crystal compound is hybrid-aligned can also be used as the alignment film.

The aligning step is a step of aligning the liquid crystal component (particularly, the dichroic substance) contained in the coating film. In the aligning step, the dichroic substance is considered to be aligned along the liquid crystal compound aligned by the alignment film.

The aligning step may have a drying treatment. By the drying treatment, components such as a solvent can be removed from the coating film. The drying treatment may be performed by a method of leaving the coating film for a predetermined time at room temperature (for example, natural drying), or a heating and/or air blowing method.

The aligning step preferably has a heating treatment. In this manner, the dichroic substance contained in the coating film is further aligned, and the alignment degree of the dichroic substance is further increased.

From the viewpoint of manufacturing suitability and the like, the heating treatment is preferably performed at 10°C to 250°C, and more preferably 25°C to 190°C. Further, the heating time is preferably 1 to 300 seconds, and more preferably 1 to 60 seconds.

In addition, from the viewpoint of easily making a difference in the alignment degrees at wavelengths of 450 nm, 550 nm, and 650 nm of the light absorption anisotropic layer to be manufactured 0.025 or less, it is preferable that the heating treatment is performed a plurality of times (particularly, twice).

The aligning step may have a cooling treatment to be performed after the heating treatment. The cooling treatment is a treatment of cooling the heated coating film to approximately 20°C to 45°C. In this manner, the alignment of the dichroic substance contained in the coating film is further fixed, and the alignment degree of the dichroic substance is further increased. The cooling means is not particularly limited, and the cooling can be performed by a known method.

In addition, the cooling treatment performed between the two heating treatments is preferably a treatment of cooling the coating film after the first heating treatment to about 30°C to 45°C, from the reason that it is easy to make a difference in the alignment degrees at wavelengths of 450 nm, 550 nm, and 650 nm of the light absorption anisotropic layer to be manufactured 0.025 or less.

The light absorption anisotropic layer according to the embodiment of the present invention can be obtained by performing the above-described steps.

The present production method may have a step of curing the light absorption anisotropic layer after the aligning step (hereinafter, also referred to as "curing step").

For example, the curing step is performed by heating and/or light irradiation (exposure). Among these, light irradiation is preferably performed to conduct the curing step.

Various light sources such as infrared rays, visible light, and ultraviolet rays can be used as the light source for curing, but ultraviolet rays are preferable. In addition, in the curing, ultraviolet rays may be applied while heating is performed. Otherwise, ultraviolet rays may be applied via a filter which transmits only a component with a specific wavelength.

In addition, exposure may be performed under a nitrogen atmosphere. In a case where curing of the light absorption anisotropic layer proceeds by radical polymerization, inhibition of the polymerization by oxygen is reduced, and thus the exposure is preferably performed under a nitrogen atmosphere.

The thickness of the light absorption anisotropic layer is not particularly limited, but from the viewpoint that the effects of the present invention are more excellent, the thickness is preferably 0.5 to 7 μm, and more preferably 1.0 to 3 μm.

[Liquid Crystal Cell]

The liquid crystal cell in the optical laminate according to the embodiment of the present invention is not particularly limited as long as it is a liquid crystal cell constituting a liquid crystal panel that is electrically birefringently switchable.

It is preferable that such a liquid crystal cell is in a vertical alignment (VA) mode, an optically compensated bend (OCB) mode, an in-plane-switching (IPS) mode, or a twisted nematic (TN) mode, but the present invention is not limited thereto.

In the present invention, from the reason that the viewing angle can be easily switched by turning on and off a voltage, it is preferable that the liquid crystal cell is a cell in which a VA mode is employed and an in-plane phase difference at a wavelength of 550 nm can be switched between 0 nm and 120 to 160 nm or between 0 nm and 250 to 300 nm.

Here, in a case where the above-described liquid crystal cell (VA mode) is used, an aspect in which, among the first light absorption anisotropic layer and the second light absorption anisotropic layer, the light absorption anisotropic layer disposed on the visible side in a case of being used in the image display device is the specific light absorption anisotropic layer, and the other is the other light absorption anisotropic layer (particularly, a light absorption anisotropic layer having a transmittance central axis in a plane) is preferable.

In addition, in the above-described aspect, from the viewpoint of switching the viewing angle to up-down light shielding (left-right transmission) and omnidirectional transmission, it is preferable to dispose the in-plane slow axis of the liquid crystal layer that appears in a case where a voltage is applied to the liquid crystal cell (VA mode) and the transmission axis of the other light absorption anisotropic layer so that an angle between the in-plane slow axis and the transmission axis is 45°.

In the present invention, from the reason that the viewing angle can be easily switched by turning on and off a voltage, it is preferable that the liquid crystal cell is a cell in an IPS mode and has an in-plane phase difference of 120 to 160 nm or 250 to 300 nm at a wavelength of 550 nm.

Here, in a case where the above-described liquid crystal cell (IPS mode) is used, an aspect in which, among the first light absorption anisotropic layer and the second light absorption anisotropic layer, the light absorption anisotropic layer disposed on the visible side in a case of being used in the image display device is the specific light absorption anisotropic layer, and the other is the other light absorption anisotropic layer (particularly, a light absorption anisotropic

layer having a transmittance central axis in a plane) is preferable.

In addition, in the above-described aspect, from the viewpoint of switching the viewing angle to the up-down light shielding (left-right transmission) and the left-right light shielding (up-down transmission), it is preferable that the liquid crystal layer of the liquid crystal cell (IPS mode) is provided such that the angle between the in-plane slow axis of the liquid crystal layer in a case where the voltage was turned on and the transmission axis of the other light absorption anisotropic layer is 0° and the angle between the in-plane slow axis of the liquid crystal layer in a case where the voltage was turned off and the transmission axis of the other light absorption anisotropic layer is 45°.

In the present invention, from the reason that the viewing angle can be easily switched by turning on and off a voltage, it is preferable that the liquid crystal cell is a cell in which a TN mode is employed and a twisted angle of alignment (twisted angle) can be switched between 0° and 90° or between 0° and 270°.

Here, in a case where the liquid crystal cell (TN mode) is used, it is preferable that the first light absorption anisotropic layer and the second light absorption anisotropic layer are any of an aspect in which both the first light absorption anisotropic layer and the second light absorption anisotropic layer are the specific light absorption anisotropic layers; and an aspect in which, among the first light absorption anisotropic layer and the second light absorption anisotropic layer, the light absorption anisotropic layer disposed on the visible side in a case of being used in an image display device is the specific light absorption anisotropic layer and the other is the other light absorption anisotropic layer (light absorption anisotropic layer having a transmittance central axis in a plane).

In the former aspect, the viewing angle can be switched to omnidirectional transmission and omnidirectional light shielding by switching the twisted angle to 0° and 90°, and in the latter aspect, the viewing angle can be switched to up-down light shielding (left-right transmission) and left-right light shielding (up-down transmission) by switching the twisted angle to 0° and 90°.

[Support]

The optical laminate according to the embodiment of the present invention may include a support.

The kind of the support is not particularly limited, and known supports can be used. In particular, a transparent support is preferable. The transparent support is intended to refer to a support having a visible light transmittance of 60% or more, which preferably has a visible light transmittance of 80% or more, and more preferably 90% or more.

Examples of the support include a glass substrate and a polymer film.

Examples of a material of the polymer film include cellulose-based polymers; acrylic polymers having an acrylic acid ester polymer such as polymethyl methacrylate and a lactone ring-containing polymer; thermoplastic norbornene-based polymers; polycarbonate-based polymers; polyester-based polymers such as polyethylene terephthalate and polyethylene naphthalate; styrene-based polymers such as polystyrene and an acrylonitrile-styrene copolymer; polyolefin-based polymers such as polyethylene, polypropylene, and an ethylenepropylene copolymer; vinyl chloride-based polymers; amide-based polymers such as nylon and aromatic polyamide; imide-based polymers; sulfone-based polymers; polyether sulfone-based polymers; polyether ether ketone-based polymers; polyphenylene sulfide-based polymers; vinylidene chloride-based polymers; vinyl alcohol-based polymers; vinyl butyral-based polymers; arylate-based polymers; polyoxymethylene-based polymers; epoxy-based polymers; and polymers obtained by mixing these polymers.

In addition, the support is preferably peelable.

[Alignment Film]

In a case where the above-described light absorption anisotropic layer is a layer formed of a composition containing a liquid crystal compound, the optical laminate according to the embodiment of the present invention preferably has an alignment film as a layer adjacent to the above layer.

Specific examples of the alignment film include a layer formed of polyvinyl alcohol, polyimide, or the like, which has been or has not been subjected to a rubbing treatment; and a photo-alignment film formed of polyvinyl cinnamate, an azo-based dye, or the like, which has been or has not been subjected to a polarizing exposure treatment.

The thickness of the alignment film is preferably 0.01 to 10 μm, and more preferably 0.01 to 1 μm.

[Pressure Sensitive Adhesive Layer]

The optical laminate according to the embodiment of the present invention may have a pressure sensitive adhesive layer.

The pressure sensitive adhesive layer is preferably a transparent and optically isotropic adhesive similar to that used in a typical image display device, and a pressure sensitive type adhesive is typically used.

The pressure sensitive adhesive layer may be blended with appropriate additives such as a crosslinking agent (for example, an isocyanate-based crosslinking agent and an epoxy-based crosslinking agent), a viscosity imparting

agent (for example, a rosin derivative resin, a polyterpene resin, a petroleum resin, and an oil-soluble phenol resin), a plasticizer, a filler, an antiaging agent, a surfactant, an ultraviolet absorbing agent, a light stabilizer, and an antioxidant in addition to a parent material (pressure sensitive adhesive), conductive particles, and thermally expandable particles used as necessary.

[Adhesive Layer]

The optical laminate according to the embodiment of the present invention may have an adhesive layer.
The adhesive layer exhibits adhesiveness due to drying or a reaction after bonding.
A polyvinyl alcohol-based adhesive (PVA-based adhesive) exhibits adhesiveness due to drying, and is capable of bonding materials to each other.
Specific examples of the curable adhesive which exhibits adhesiveness due to a reaction include an active energy ray-curable adhesive such as a (meth)acrylate-based adhesive and a cationic polymerization curable adhesive. The (meth)acrylate denotes acrylate and/or methacrylate. Examples of the curable component in the (meth)acrylate-based adhesive include a compound having a (meth)acryloyl group and a compound having a vinyl group. In addition, as the cationic polymerization curable adhesive, a compound having an epoxy group or an oxetanyl group can also be used. The compound having an epoxy group is not particularly limited as long as it has at least two epoxy groups in the molecule, and various generally known curable epoxy compounds can be used. Preferable examples of the epoxy compound include a compound (aromatic epoxy compound) having at least two epoxy groups and at least one aromatic ring in the molecule and a compound (alicyclic epoxy compound) having at least two epoxy groups in the molecule, in which at least one of the epoxy groups is formed between two adjacent carbon atoms constituting an alicyclic ring.
Among these, from the viewpoint of heat deformation resistance, an ultraviolet curable adhesive which is cured by irradiation with ultraviolet rays is preferably used.

[B-plate]

The optical laminate according to the embodiment of the present invention may have a B-plate.
The B-plate is either a positive B-plate or a negative B-plate.
The positive B-plate satisfies a relationship of Expression (B 1) and the negative B-plate satisfies a relationship of Expression (B2), assuming that a refractive index in a film in-plane slow axis direction (in a direction in which an in-plane refractive index is maximum) is defined as nx, a refractive index in an in-plane direction orthogonal to the in-plane slow axis is defined as ny, and a refractive index in a thickness direction is defined as nz.

$$\text{Expression (B1)}\quad nz > nx > ny$$

$$\text{Expression (B2)}\quad nx > ny > nz$$

The positive B-plate has a negative value of the thickness direction retardation, and the negative B-plate has a positive value of the thickness direction retardation.
An in-plane retardation of the B-plate at a wavelength of 550 nm is not particularly limited, but from the viewpoint that the effect of the present invention is more excellent, it is preferably 100 to 200 nm and more preferably 150 to 200 nm.
An absolute value of a thickness direction retardation of the B-plate at a wavelength of 550 nm is not particularly limited, but from the viewpoint that the effect of the present invention is more excellent, it is preferably 100 to 500 nm and more preferably 120 to 400 nm.
A material constituting the B-plate is not particularly limited, and the B-plate may be a layer formed of a liquid crystal compound or a resin film.

[Image Display Device]

The image display device according to the embodiment of the present invention is an image display device having a viewing angle switching function, which has the above-described optical laminate according to the embodiment of the present invention, and is preferably an image display device in which the specific light absorption anisotropic layer in the above-described optical laminate according to the embodiment of the present invention is disposed to be on the visible side.
In addition, in the image display device according to the embodiment of the present invention, an aspect in which a viewing angle of a plurality of regions in the display screen can be independently switched may be employed.

[Display Element]

The display element used in the image display device according to the embodiment of the present invention is not particularly limited, and examples thereof include a liquid crystal cell, an organic electroluminescence (hereinafter, abbreviated as "EL") display panel, a plasma display panel, and a micro LED.
Among these, the liquid crystal cell, the organic EL display panel, or the micro LED is preferable. That is, the display device according to the embodiment of the present invention is preferably a liquid crystal display device using a liquid crystal cell as a display element, an organic EL display device using an organic EL display panel as a display element, or a micro LED display device using an inorganic EL light emitting element as a display element.
Some image display devices are thin and can be formed into a curved surface. Since the optical anisotropic absorption film used in the present invention is thin and easily bent, the film can be suitably applied to an image display device having a curved display surface.
In addition, some image display devices have a pixel density of more than 250 ppi and are capable of high-definition display. The optical anisotropic absorption film used in the present invention can be suitably applied to such a high-definition image display device without causing moire.
Further, the micro LED may be an EL substrate formed such that light emitting units 24 including the R light emitting element 12R, the G light emitting element 12G, and the B light emitting element 12B, which are fine inorganic EL light emitting elements, are twodimensionally arranged, as conceptually illustrated in Fig. 1.

Examples

Hereinafter, the present invention will be described in more detail with reference to Examples. Materials, used amounts, ratios, treatment contents, treatment procedures, and the like described in the following examples can be appropriately changed without departing from the gist of the present invention. Therefore, the range of the present invention will not be restrictively interpreted by the following examples.

[Example 1]

[Formation of Light Absorption Anisotropic Layer A1]

<Formation of Alignment Film 1>

A surface of a cellulose acylate film (TAC base material; manufactured by FUJIFILM Corporation, TG40) with a thickness of 40 μm was saponified with an alkaline solution, and coated with the following composition 1 for forming an alignment film using a wire bar.
The support with the coating film formed thereon was dried with hot air at 60°C for 60 seconds and further dried with hot air at 100°C for 120 seconds to form an alignment film 1, thereby obtaining a TAC film with an alignment film.
The alignment film 1 had a film thickness of 1 μm.

| Composition 1 for Forming Alignment Film | |
|---|---|
| · Modified polyvinyl alcohol PVA-1 shown below | 3.80 parts by mass |
| · IRGACURE 2959 | 0.20 parts by mass |
| · Water | 70 parts by mass |
| · Methanol | 30 parts by mass |

Modified Polyvinyl Alcohol PVA-1

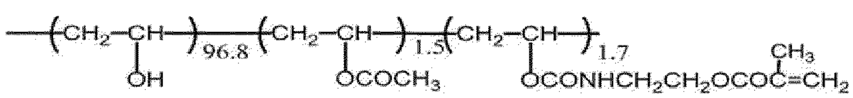

<Formation of Light Absorption Anisotropic Layer A1>

The obtained alignment film 1 was continuously coated with the following composition 1 for forming a light

absorption anisotropic layer using a wire bar, heated at 120°C for 60 seconds, and then cooled to 35°C. Next, the coating was heated at 80°C for 60 seconds and cooled to room temperature again.

Thereafter, the coating was irradiated with ultraviolet rays from an LED lamp (central wavelength: 365 nm) for 2 seconds under irradiation conditions of an illuminance of 200 mW/$cm^2$, thereby forming a light absorption anisotropic layer A1 on the alignment film 1. The light absorption anisotropic layer A1 had a film thickness of 3.5 μm.

| Composition of composition 1 for forming light absorption anisotropic layer | |
|---|---|
| · Dichroic substance D-1 shown below | 0.63 parts by mass |
| · Dichroic substance D-2 shown below | 0.17 parts by mass |
| · Dichroic substance D-3 shown below | 1.13 parts by mass |
| · Polymer liquid crystal compound P-1 shown below | 7.12 parts by mass |
| · Low-molecular-weight liquid crystal compound M-1 shown below | 1.00 parts by mass |
| · IRGACURE OXE-02 (manufactured by BASF SE) | 0.16 parts by mass |
| · Compound E-1 shown below | 0.12 parts by mass |
| · Compound E-2 shown below | 0.12 parts by mass |
| · Surfactant F-1 shown below | 0.05 parts by mass |
| · Cyclopentanone | 85.00 parts by mass |
| · Benzyl alcohol | 4.50 parts by mass |

Dichroic Substance D-1

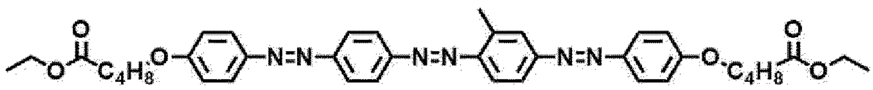

Dichroic Substance D-2

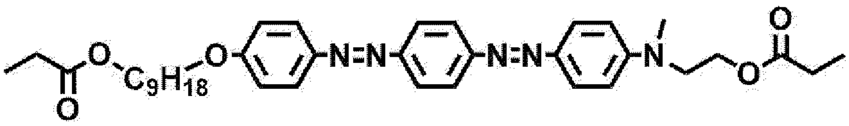

Dichroic Substance D-3

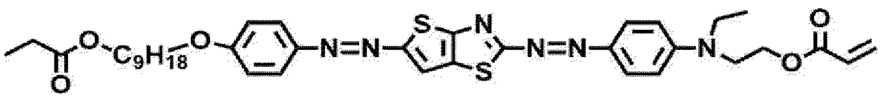

Polymer Liquid Crystal Compound P-1

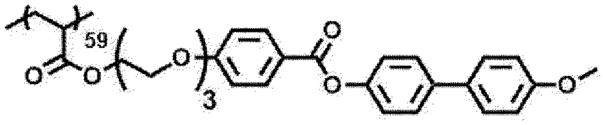

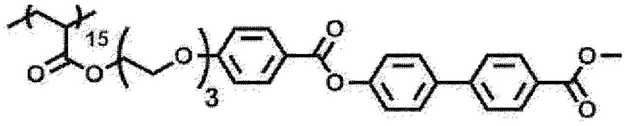

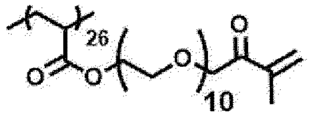

Low-molecular-weight liquid crystal compound M-1

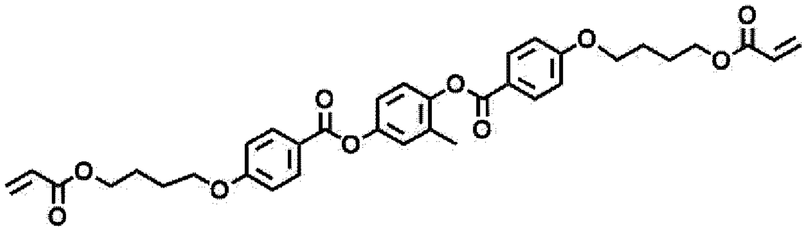

Compound E-1

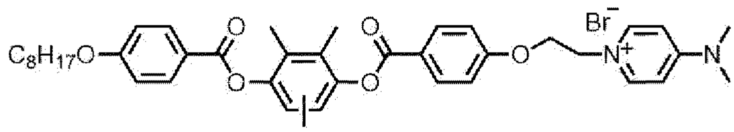

Compound E-2

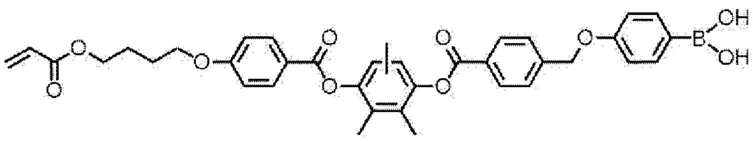

Surfactant F-1

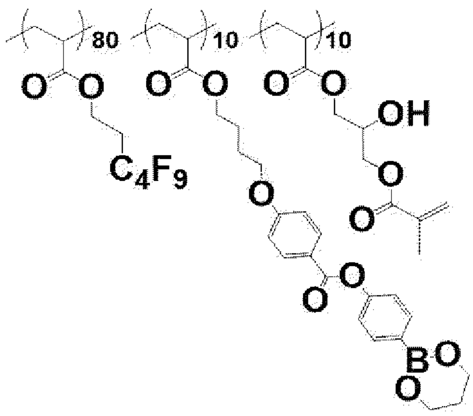

For the produced light absorption anisotropic layer A1, an angle (hereinafter, abbreviated as a "transmittance central axis angle θ") formed by a transmittance central axis of the light absorption anisotropic layer and a normal direction

of a surface of the light absorption anisotropic layer, an alignment degree at wavelengths of 450, 550, and 650 nm and a difference (ΔS) therebetween, and a haze value were measured by the above-described method. The results are shown in Table 1 below.

[Formation of Oxygen-Shielding Layer B1]

The formed light absorption anisotropic layer A1 was continuously coated with a coating solution having the following composition (composition B1 for forming an oxygen-shielding layer) using a wire bar. Thereafter, the layer was dried with hot air at 100°C for 2 minutes, thereby forming a polyvinyl alcohol (PVA) alignment layer (oxygen-shielding layer B1) having a thickness of 0.5 μm on the light absorption anisotropic layer A.

In this manner, an optical film 1 in which the cellulose acylate film, the alignment film 1, the light absorption anisotropic layer A1, and the oxygen-shielding layer B1 were adjacent to each other in this order was obtained.

| Composition of Composition B1 for Forming Oxygen-Shielding Layer | |
|---|---|
| · Modified polyvinyl alcohol PVA-1 shown above | 3.80 parts by mass |
| · Polymerization initiator IRGACURE 2959 (manufactured by BASF SE) | 0.20 parts by mass |
| · Water | 70 parts by mass |
| · Methanol | 30 parts by mass |

[Production of TN Liquid Crystal Cell for Viewing Angle Switching]

Two glass substrates with ITO electrodes were coated with a horizontal alignment polyimide alignment film, dried at a high temperature to form an alignment film, and then subjected to a rubbing treatment so that a TN cell could be formed. Specifically, an alignment treatment was performed so as to impart a 90° twist in the vertical direction.

Thereafter, a thermosetting sealing material was sprayed to one of the two substrates, and a bead spacer (diameter of 5 μm) was sprayed to the other substrate, and the two substrates were bonded to each other, vacuum-packed, and subjected to a heating treatment, thereby forming an empty liquid crystal cell.

A liquid crystal with positive dielectric anisotropy, a refractive index anisotropy Δn of 0.0854 (589 nm, 20°C), and Δε of +8.5 (MLC-9100, manufactured by Merck KGaA) was injected to the cell using a vacuum liquid crystal injector, and the cell was subjected to a sealing treatment, thereby producing a TN liquid crystal cell having Δnd of 450 nm.

Further, since the inner surfaces of the upper and lower substrates were subjected to a rubbing treatment, the liquid crystal layer was twistedly aligned at a twisted angle of 90° between the upper and lower substrates at the time of no voltage application, and a TN liquid crystal cell in which liquid crystals were aligned in the vertical direction by applying the voltage was completed. Further, a liquid crystal cell having a twisted structure with an optional Δnd was able to be formed by adjusting the spacer diameter.

[Production of Optical Laminate (Viewing Angle Switching Cell)]

The optical film 1 produced above was bonded to both surfaces of the TN liquid crystal cell produced above using a commercially available pressure sensitive adhesive SK2057 (manufactured by Soken Chemical & Engineering Co., Ltd.) such that the oxygen-shielding layer B1 side in the optical film 1 was on the TN liquid crystal cell side, thereby producing an optical laminate A1.

[Production of Image Display Device Having Viewing Angle Switching Function]

COSMOSHINE super-birefringent type (SRF, manufactured by Toyobo Co., Ltd.) (depolarization film) was bonded to a display screen of a dynabook (manufactured by Toshiba Corporation) which is a laptop computer equipped with a liquid crystal display device, using a commercially available pressure sensitive adhesive SK2057 (manufactured by Soken Chemical & Engineering Co., Ltd.).

Next, the optical laminate A1 produced above was placed on the depolarization film to produce an image display device A1 having a viewing angle switching function.

It was found that in the produced image display device A1, the twisted angle was switched to 0° and 90° by turning on and off the voltage of the TN liquid crystal cell, and accordingly, the viewing angle could be switched to omnidirectional transmission and omnidirectional light shielding.

[Example 2]

[Production of Image Display Device A2 Having Viewing Angle Switching Function]

An image display device A2 having a viewing angle switching function was produced in the same manner as in Example 1, except that the composition 1 for forming a light absorption anisotropic layer was changed to the following composition 2 for forming a light absorption anisotropic layer.
The transmittance central axis angle θ, the alignment degree at wavelengths of 450, 550, and 650 nm, the difference (ΔS) therebetween, and the haze value of the light absorption anisotropic layer formed of the following composition 2 for forming a light absorption anisotropic layer were measured by the above-described method. The results are shown in Table 1 below.
Further, it was found that in the produced image display device A2, the twisted angle was switched to 0° and 90° by turning on and off the voltage of the TN liquid crystal cell, and accordingly, the viewing angle could be switched to omnidirectional transmission and omnidirectional light shielding.

| Composition of composition 2 for forming light absorption anisotropic layer | |
|---|---|
| · Dichroic substance D-1 shown above | 0.75 parts by mass |
| · Dichroic substance D-2 shown above | 0.13 parts by mass |
| · Dichroic substance D-3 shown above | 1.05 parts by mass |
| · Polymer liquid crystal compound P-1 shown above | 7.12 parts by mass |
| · Low-molecular-weight liquid crystal compound M-1 shown above | 1.00 parts by mass |
| · IRGACURE OXE-02 (manufactured by BASF SE) | 0.16 parts by mass |
| · Compound E-1 shown above | 0.12 parts by mass |
| · Compound E-2 shown above | 0.12 parts by mass |
| · Surfactant F-1 described above | 0.05 parts by mass |
| · Cyclopentanone | 85.00 parts by mass |
| · Benzyl alcohol | 4.50 parts by mass |

[Example 3]

[Production of Image Display Device A3 Having Viewing Angle Switching Function]

An image display device A3 having a viewing angle switching function was produced in the same manner as in Example 1, except that, in the formation of the light absorption anisotropic layer A1, the heating temperature of 80°C after cooling at 35°C was changed to 75°C.
The transmittance central axis angle θ, the alignment degree at wavelengths of 450, 550, and 650 nm, the difference (ΔS) therebetween, and the haze value of the light absorption anisotropic layer formed by changing the heating temperature were measured by the above-described method. The results are shown in Table 1 below.
It was found that in the produced image display device A3, the twisted angle was switched to 0° and 90° by turning on and off the voltage of the TN liquid crystal cell, and accordingly, the viewing angle could be switched to omnidirectional transmission and omnidirectional light shielding.

[Example 4]

[Production of Polarizing Plate]

A polarizing plate in which a thickness of a polarizer was 8 μm and one surface of the polarizer (the other light absorption anisotropic layer) was exposed was produced by the same method as that for a polarizing plate 02 with a one-surface protective film, described in WO2015/166991A.

[Production of Optical Laminate (Viewing Angle Switching Cell)]

The polarizing plate produced above was bonded to one surface of the TN liquid crystal cell produced in Example 1 using a commercially available pressure sensitive adhesive SK2057 (manufactured by Soken Chemical & Engineering Co., Ltd.) such that the polarizer surface was on the TN liquid crystal side.
Next, the optical film 1 produced in Example 1 was bonded to the surface of the TN liquid crystal cell opposite to the surface to which the polarizing plate was bonded, using a commercially available pressure sensitive adhesive SK2057

(manufactured by Soken Chemical & Engineering Co., Ltd.) so that the oxygen-shielding layer B1 side was on the TN liquid crystal cell side, thereby producing an optical laminate A4.

[Production of Image Display Device Having Viewing Angle Switching Function]

An image display device A4 having a viewing angle switching function was produced in the same manner as in Example 1, except that the optical laminate A1 was changed to the optical laminate A4. In this case, the light absorption anisotropic layer A1 (specific light absorption anisotropic layer) in the optical laminate A4 was provided so as to be on the visible side of the image display device.

It was found that in the produced image display device A4, the twisted angle was switched to 0° and 90° by turning on and off the voltage of the TN liquid crystal cell, and accordingly, the viewing angle could be switched to up-down transmission (left-right transmission) and left-right light shielding (up-down light shielding).

[Example 5]

[Production of VA Liquid Crystal Cell 1 for Viewing Angle Switching]

A liquid crystal material (MLC6608, manufactured by Merck KGaA) having negative dielectric anisotropy was dropwise injected between glass substrates, and a liquid crystal layer was formed between the glass substrates to produce a VA liquid crystal cell 1. The film thickness of the liquid crystal layer was adjusted such that the in-plane retardation of the liquid crystal layer (that is, the product $\Delta n \cdot d$ of the thickness d ($\mu$m) of the liquid crystal layer and the refractive index anisotropy $\Delta n$) was 140 nm ($\lambda/4$).

The liquid crystal material was aligned to be vertically aligned, and a voltage was applied thereto to complete the VN liquid crystal cell 1 in which the liquid crystal was aligned in the horizontal direction and an in-plane retardation was exhibited.

[Production of Optical Laminate (Viewing Angle Switching Cell)]

A polarizing plate produced in Example 4 was bonded to one surface of the VN liquid crystal cell 1 produced above using a commercially available pressure sensitive adhesive SK2057 (manufactured by Soken Chemical & Engineering Co., Ltd.) such that the polarizer surface was on the VN liquid crystal cell side.

Next, the optical film 1 produced in Example 1 was bonded to the surface of the VN liquid crystal cell 1 opposite to the surface to which the polarizing plate was bonded, using a commercially available pressure sensitive adhesive SK2057 (manufactured by Soken Chemical & Engineering Co., Ltd.) so that the oxygen-shielding layer B1 side was on the VN liquid crystal cell side, thereby producing an optical laminate A5. In this case, the VA liquid crystal cell 1 was provided such that the angle between the in-plane slow axis of the liquid crystal layer (horizontal alignment) in a case where a voltage was applied to the VA liquid crystal cell 1 and the transmission axis of the polarizer (the other light absorption anisotropic layer) was 45°.

[Production of Image Display Device Having Viewing Angle Switching Function]

An image display device A5 having a viewing angle switching function was produced in the same manner as in Example 4, except that the optical laminate A4 was changed to the optical laminate A5.

It was found that in the produced image display device A5, the in-plane retardation of the liquid crystal layer was switched to 0 and $\lambda/4$ by turning off and on the voltage of the VA liquid crystal cell, and accordingly, the viewing angle could be switched to up-down light shielding (left-right transmission) and omnidirectional transmission.

[Example 6]

In the production of the VA liquid crystal cell 1 for viewing angle switching in Example 5, a VA liquid crystal cell 2 was produced using the same procedure as that of the VA liquid crystal cell 1, except that the film thickness of the liquid crystal layer was changed such that the retardation of the liquid crystal layer of 140 nm was 275 nm ($\lambda/2$).

An image display device A6 having a viewing angle switching function was produced in the same manner as in Example 5, except that the VA liquid crystal cell 1 was changed to the VA liquid crystal cell 2.

It was found that in the produced image display device A6, the in-plane retardation of the liquid crystal layer was switched to 0 and $\lambda/2$ by turning off and on the voltage of the VA liquid crystal cell, and accordingly, the viewing angle could be switched to up-down light shielding (left-right transmission) and left-right light shielding (up-down transmission).

[Example 7]

[Production of IPS Liquid Crystal Cell for Viewing Angle Switching]

An IPS liquid crystal cell having a liquid crystal layer between two glass substrates was produced. In the formation of the liquid crystal cell, a glass substrate was subjected to a photo-alignment treatment with reference to Example 11 of JP2005-351924A to form an alignment layer, and a liquid crystal compound in the liquid crystal cell was aligned. The tilt angle of the liquid crystal compound with respect to the substrate surface was 0.1°. Δn of the liquid crystal compound in the liquid crystal layer was 0.08625 at a wavelength of 550 nm, and Δnd was adjusted by adjusting an interval (gap; d) between the substrates. The in-plane retardation of the liquid crystal layer was 275 nm (λ/2).

[Production of Optical Laminate (Viewing Angle Switching Cell)]

A polarizing plate produced in Example 4 was bonded to one surface of the IPS liquid crystal cell produced above using a commercially available pressure sensitive adhesive SK2057 (manufactured by Soken Chemical & Engineering Co., Ltd.) such that the polarizer surface was on the IPS liquid crystal cell side.

Next, the optical film 1 produced in Example 1 was bonded to the surface of the IPS liquid crystal cell opposite to the surface to which the polarizing plate was bonded, using a commercially available pressure sensitive adhesive SK2057 (manufactured by Soken Chemical & Engineering Co., Ltd.) so that the oxygen-shielding layer B1 side was on the IPS liquid crystal cell side, thereby producing an optical laminate A7. In this case, the liquid crystal layer in the IPS liquid crystal cell was provided such that the angle between the in-plane slow axis of the liquid crystal layer in a case where the voltage was turned on and the transmission axis of the polarizer (the other light absorption anisotropic layer) was 0° and the angle between the in-plane slow axis of the liquid crystal layer in a case where the voltage was turned off and the transmission axis of the polarizer (the other light absorption anisotropic layer) was 45°.

[Production of Image Display Device Having Viewing Angle Switching Function]

An image display device A7 having a viewing angle switching function was produced in the same manner as in Example 4, except that the optical laminate A4 was changed to the optical laminate A7.

In the produced image display device A7, it was found that the angle between the in-plane slow axis of the liquid crystal layer in the ISP liquid crystal cell and the transmission axis of the polarizer (the other light absorption anisotropic layer) was switched to 0° and 45° by turning on and off the voltage of the IPS liquid crystal cell, and accordingly, the viewing angle could be switched to up-down light shielding (left-right transmission) and left-right light shielding (up-down transmission).

[Example 8]

<Formation of Alignment Film 2>

A TAC film with an alignment film was produced in the same manner as in Example 1, and the alignment layer was coated with the following composition liquid E1 for forming a photo-alignment layer and dried at 60°C for 2 minutes. Thereafter, the obtained coating film was irradiated with ultraviolet rays (irradiation amount: 2000 $mJ/cm^2$) from an oblique direction using an ultraviolet exposure device to produce an alignment film 2 (photo-alignment film) having a thickness of 0.03 μm.

<Preparation of Composition Liquid E1 for Forming Photo-alignment Layer>

The composition liquid E1 for forming a photo-alignment layer was prepared with the following composition, dissolved for 1 hour while being stirred, and filtered through a filter with a hole diameter of 0.45 μm.

| Composition liquid E1 for forming photo-alignment layer | |
|---|---|
| · Photo-alignment material E-1 shown below | 0.3 parts by mass |
| · 2-Butoxyethanol | 41.6 parts by mass |
| · Dipropylene glycol monomethyl ether | 41.6 parts by mass |
| · Pure water | 16.5 parts by mass |

Photo-alignment Material E-1

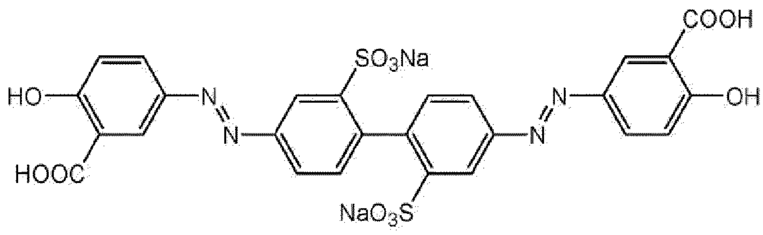

[Formation of Light Absorption Anisotropic Layer A8]

A light absorption anisotropic layer A8 was produced in the same manner as in Example 1, except that the alignment film 1 was changed to the alignment film 2.

The transmittance central axis angle θ, the alignment degree at wavelengths of 450, 550, and 650 nm, the difference (ΔS) therebetween, and the haze value of the produced light absorption anisotropic layer A8 were measured by the above-described method. The results are shown in Table 2.

[Production of Image Display Device Having Viewing Angle Switching Function]

An image display device A8 having a viewing angle switching function was produced in the same manner as in Example 1 except that the light absorption anisotropic layer A1 was changed to the light absorption anisotropic layer A8.

It was found that in the produced image display device A8, the twisted angle was switched to 0° and 90° by turning on and off the voltage of the TN liquid crystal cell, and accordingly, the viewing angle could be switched to omnidirectional transmission and omnidirectional light shielding.

[Example 9]

[Production of Image Display Device A9 Having Viewing Angle Switching Function]

An image display device A9 having a viewing angle switching function was produced in the same manner as in Example 1, except that the composition 1 for forming a light absorption anisotropic layer was changed to the following composition 3 for forming a light absorption anisotropic layer.

The transmittance central axis angle θ, the alignment degree at wavelengths of 450, 550, and 650 nm, the difference (ΔS) therebetween, and the haze value of the light absorption anisotropic layer formed of the following composition 3 for forming a light absorption anisotropic layer were measured by the above-described method. The results are shown in Table 2.

Further, it was found that in the produced image display device A9, the twisted angle was switched to 0° and 90° by turning on and off the voltage of the TN liquid crystal cell, and accordingly, the viewing angle could be switched to omnidirectional transmission and omnidirectional light shielding.

| Composition of composition 3 for Forming Light Absorption Anisotropic Layer | |
|---|---|
| · Dichroic substance D-1 shown above | 1.82 parts by mass |
| · Dichroic substance D-4 shown below | 0.49 parts by mass |
| · Dichroic substance D-5 shown below | 3.25 parts by mass |
| · Polymer liquid crystal compound P-2 shown below | 18.21 parts by mass |
| · Low-molecular-weight liquid crystal compound M-2 shown below | 4.13 parts by mass |
| · IRGACURE 369 (manufactured by BASF SE) | 1.67 parts by mass |
| . Compound E-1 shown above | 0.37 parts by mass |
| . Compound E-2 shown above | 0.37 parts by mass |
| · BYK-361N (manufactured by BYK-Chemie GmbH) | 0.084 parts by mass |
| · o-xylene | 69.60 parts by mass |

Dichroic substance D-4

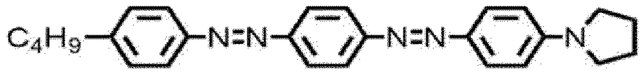

Dichroic Substance D-5

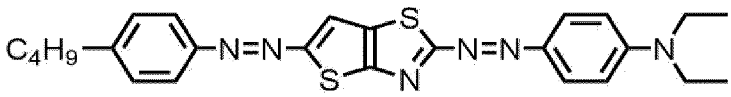

Polymer liquid crystal compound P-2

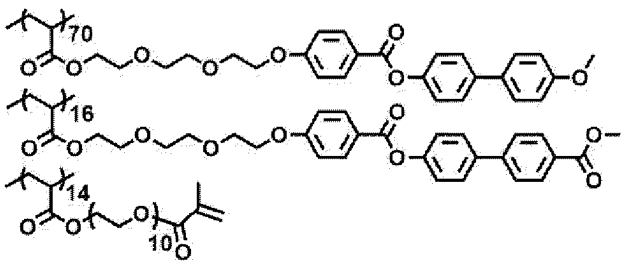

Low-molecular-weight liquid crystal compound M-2 [mixture of the following liquid crystal compounds (RA), (RB), and (RC) at a mass ratio of 84:14:2]

(RA) 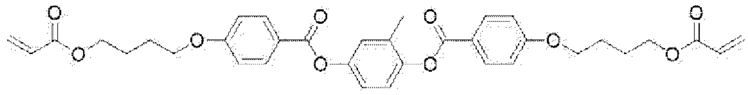

(RB) 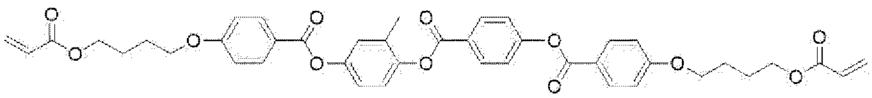

(RC) 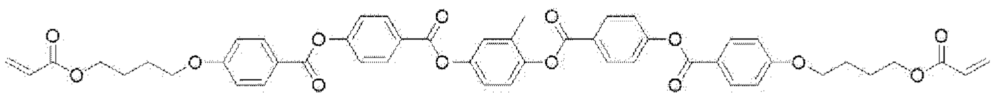

[Example 10]

[Production of Image Display Device A10 Having Viewing Angle Switching Function]

An image display device A10 having a viewing angle switching function was produced in the same manner as in Example 1, except that the composition 1 for forming a light absorption anisotropic layer was changed to the following composition 4 for forming a light absorption anisotropic layer.

The transmittance central axis angle θ, the alignment degree at wavelengths of 450, 550, and 650 nm, the difference (ΔS) therebetween, and the haze value of the light absorption anisotropic layer formed of the following composition 4 for forming a light absorption anisotropic layer were measured by the above-described method. The

results are shown in Table 2.

Further, it was found that in the produced image display device A10, the twisted angle was switched to 0° and 90° by turning on and off the voltage of the TN liquid crystal cell, and accordingly, the viewing angle could be switched to omnidirectional transmission and omnidirectional light shielding.

| Composition of composition 4 for forming light absorption anisotropic layer | |
|---|---|
| · Dichroic substance D-1 shown above | 0.79 parts by mass |
| · Dichroic substance D-2 shown above | 0.21 parts by mass |
| · Dichroic substance D-6 shown below | 1.41 parts by mass |
| · Low-molecular-weight liquid crystal compound M-3 shown below | 7.52 parts by mass |
| · Low-molecular-weight liquid crystal compound M-4 shown below | 2.51 parts by mass |
| · IRGACURE 369 (manufactured by BASF SE) | 0.73 parts by mass |
| · BYK-361N (manufactured by BYK-Chemie GmbH) | 0.036 parts by mass |
| · Cyclopentanone | 78.13 parts by mass |
| · Benzyl alcohol | 8.67 parts by mass |

Dichroic Substance D-6

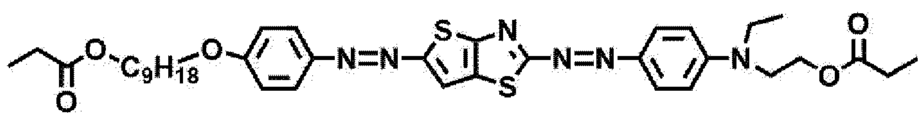

Low-molecular-weight liquid crystal compound M-3

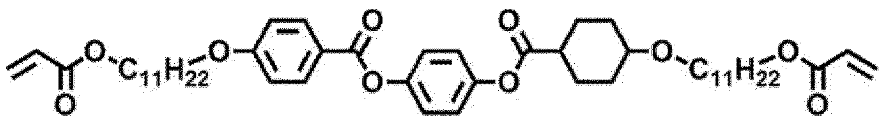

Low-molecular-weight liquid crystal compound M-4

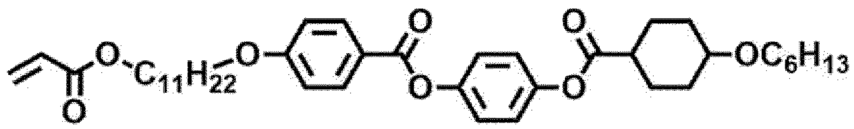

[Example 11]

[Production of Image Display Device A11 Having Viewing Angle Switching Function]

An image display device A11 having a viewing angle switching function was produced in the same manner as in Example 1, except that the composition 1 for forming a light absorption anisotropic layer was changed to the following composition 5 for forming a light absorption anisotropic layer.

The transmittance central axis angle θ, the alignment degree at wavelengths of 450, 550, and 650 nm, the difference (ΔS) therebetween, and the haze value of the light absorption anisotropic layer formed of the following composition 5 for forming a light absorption anisotropic layer were measured by the above-described method. The results are shown in Table 2.

Further, it was found that in the produced image display device A11, the twisted angle was switched to 0° and 90°

by turning on and off the voltage of the TN liquid crystal cell, and accordingly, the viewing angle could be switched to omnidirectional transmission and omnidirectional light shielding.

| Composition of composition 5 for forming light absorption anisotropic layer | |
|---|---|
| · Dichroic substance D-1 shown above | 0.78 parts by mass |
| · Dichroic substance D-4 shown above | 0.21 parts by mass |
| · Dichroic substance D-5 shown above | 1.39 parts by mass |
| · Low-molecular-weight liquid crystal compound M-3 shown above | 7.39 parts by mass |
| · Low-molecular-weight liquid crystal compound M-4 shown above | 2.46 parts by mass |
| · IRGACURE 369 (manufactured by BASF SE) | 0.71 parts by mass |
| · BYK-361N (manufactured by BYK-Chemie GmbH) | 0.036 parts by mass |
| · o-xylene | 87.02 parts by mass |

[Example 12]

[Production of B-plate]

A cycloolefin resin ARTON G7810 (manufactured by JSR Corporation) was dried at 100°C for 2 hours or more, and melt-extruded at 280°C using a twin screw kneading extruder. Here, a screen filter, a gear pump, and a leaf disc filter were arranged in this order between the extruder and a die, these were connected by a melt pipe, and the resultant was extruded from a T die having a width of 1000 mm and a lip gap of 1 mm and was cast on a triple cast roll in which temperatures were set to 180°C, 175°C, and 170°C, thereby obtaining an un-stretched film 1 having a width of 900 mm and a thickness of 320 μm.

A stretching step and a thermal fixation step were performed using the following method on the un-stretched film 1 that was being transported.

(a) Machine-Direction Stretching

The un-stretched film 1 was stretched in the machine direction under the following conditions while being transported using an inter-roll machine-direction stretching machine having an aspect ratio (L/W) of 0.2.

Preheating temperature: 170°C, stretching temperature: 170°C, and stretching ratio: 155%

(b) Cross-Direction Stretching

The film that was stretched in the machine direction was stretched in the cross-direction under the following conditions while being transported using a tenter.

Preheating temperature: 170°C, stretching temperature: 170°C, stretching ratio: 80%

After the stretching step, a heating treatment was performed on the stretched film under the following conditions while end portions of the stretched film were gripped with a tenter clip to hold both end portions of the stretched film such that the width thereof was constant (within 3% of expansion or contraction), and the stretched film was thermally fixed.

Thermal fixation temperature: 165°C, thermal fixation time: 30 seconds [0162] After the thermal fixation, both ends of the stretched film were trimmed and wound at a tension of 25 kg/m, thereby obtaining a film roll having a width of 1340 mm and a winding length of 2000 m. The obtained stretched film had an in-plane retardation of 160 nm at a wavelength of 550 nm, a thickness direction retardation of 390 nm at a wavelength of 550 nm, and a film thickness of 80 μm. The obtained film was set as a B-plate.

[Production of Optical Laminate (Viewing Angle Switching Cell)]

A polarizing plate produced in Example 4 was bonded to one surface of the IPS liquid crystal cell produced above using a commercially available pressure sensitive adhesive SK2057 (manufactured by Soken Chemical & Engineering Co., Ltd.) such that the polarizer surface was on the IPS liquid crystal cell side produced in Example 7.

Next, the B-plate produced above was bonded to a surface of the IPS liquid crystal cell opposite to the surface to which the polarizing plate was bonded, using a commercially available pressure sensitive adhesive SK2057 (manufactured by Soken Chemical & Engineering Co., Ltd.).

Next, the optical film 1 produced in Example 1 was bonded to the B-plate side using a commercially available pressure sensitive adhesive SK2057 (manufactured by Soken Chemical & Engineering Co., Ltd.) so that the oxygen-shielding layer B1 side was the B-plate side, thereby producing an optical laminate A12. In this case, the liquid crystal layer in the IPS liquid crystal cell was provided such that the angle between the in-plane slow axis of the liquid crystal layer in a case where the voltage was turned on and the transmission axis of the polarizer (the other light absorption anisotropic layer) was 0° and the angle between the in-plane slow axis of the liquid crystal layer in a case where the voltage was turned off and the transmission axis of the polarizer (the other light absorption anisotropic layer) was 45°.

[Production of Image Display Device Having Viewing Angle Switching Function]

An image display device A12 having a viewing angle switching function was produced in the same manner as in Example 4, except that the optical laminate A4 was changed to the optical laminate A12.

In the produced image display device A12, it was found that the angle between the in-plane slow axis of the liquid crystal layer in the ISP liquid crystal cell and the transmission axis of the polarizer (the other light absorption anisotropic layer) was switched to 0° and 45° by turning on and off the voltage of the IPS liquid crystal cell, and accordingly, the viewing angle could be switched to up-down light shielding (left-right transmission) and left-right light shielding (up-down transmission).

[Example 13]

[Production of Image Display Device Having Viewing Angle Switching Function]

COSMOSHINE super-birefringent type (SRF, manufactured by Toyobo Co., Ltd.) (depolarization film) was bonded to a display screen of Galaxy S7+ (manufactured by Samsung Electronics Co., Ltd.), which is a tablet equipped with an organic EL display device, using a commercially available pressure sensitive adhesive SK2057 (manufactured by Soken Chemical & Engineering Co., Ltd.).

Next, the optical laminate A7 produced in Example 7 was placed on the depolarization film to produce an image display device A13 having a viewing angle switching function.

In the produced image display device A13, it was found that the angle between the in-plane slow axis of the liquid crystal layer in the ISP liquid crystal cell and the transmission axis of the polarizer (the other light absorption anisotropic layer) was switched to 0° and 45° by turning on and off the voltage of the IPS liquid crystal cell, and accordingly, the viewing angle could be switched to up-down light shielding (left-right transmission) and left-right light shielding (up-down transmission).

[Example 14]

[Production of Image Display Device Having Viewing Angle Switching Function]

Three-color light emitting LEDs (PICOLED, model number: SMLP34RGB, manufactured by Rohm Co., Ltd.) were arranged on a printed circuit board in a two-dimensional lattice form such that the area ratio of the LEDs (light emitting elements) was 30%. A black layer formed of a black matrix material for a liquid crystal display device was formed in a portion where the LEDs were not arranged using photolithography. In this manner, an EL substrate was produced (refer to Fig. 1).

Next, the optical laminate A1 produced in Example 1 was placed on the EL substrate 1 to produce an image display device A14 having a viewing angle switching function.

Further, it was found that in the produced image display device A14, the twisted angle was switched to 0° and 90° by turning on and off the voltage of the TN liquid crystal cell, and accordingly, the viewing angle could be switched to omnidirectional transmission and omnidirectional light shielding.

[Comparative Example 1]

[Production of Image Display Device B1 Having Viewing Angle Switching Function]

In Example 1, an image display device B1 having a viewing angle switching function was produced in the same manner as in Example 1, except that the composition 1 for forming a light absorption anisotropic layer was changed to the following composition 6 for forming a light absorption anisotropic layer and the cooling temperature of 35°C after heating at 120°C was changed to 23°C.

The transmittance central axis angle θ, the alignment degree at wavelengths of 450, 550, and 650 nm, the difference (ΔS) therebetween, and the haze value of the light absorption anisotropic layer formed of the following composition 6 for forming a light absorption anisotropic layer were measured by the above-described method. The

results are shown in Table 2.

Further, it was found that in the produced image display device B1, the twisted angle was switched to 0° and 90° by turning on and off the voltage of the TN liquid crystal cell, and accordingly, the viewing angle could be switched to omnidirectional transmission and omnidirectional light shielding.

| Composition of composition 6 for forming light absorption anisotropic layer | |
|---|---|
| · Dichroic substance D-7 shown below | 0.87 parts by mass |
| · Dichroic substance D-8 shown below | 1.06 parts by mass |
| · Polymer liquid crystal compound P-3 shown below | 4.41 parts by mass |
| · IRGACURE OXE-02 (manufactured by BASF SE) | 0.005 parts by mass |
| . Compound E-1 shown above | 0.08 parts by mass |
| . Compound E-2 shown above | 0.08 parts by mass |
| · Surfactant F-2 shown below | 0.10 parts by mass |
| · Cyclopentanone | 79.39 parts by mass |
| · Tetrahydrofuran | 14.01 parts by mass |

Dichroic Substance D-7

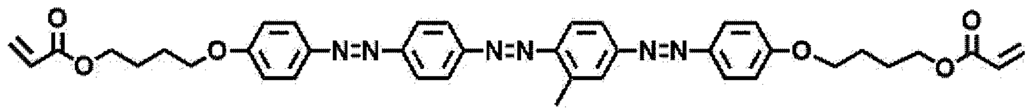

Dichroic Substance D-8

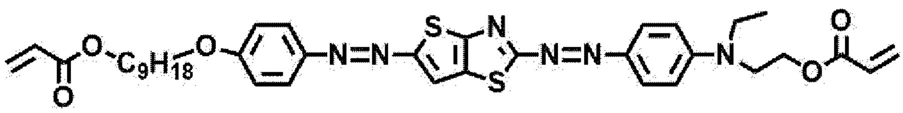

Polymer Liquid Crystal Compound P-3

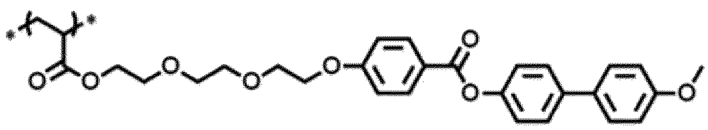

Surfactant F-2

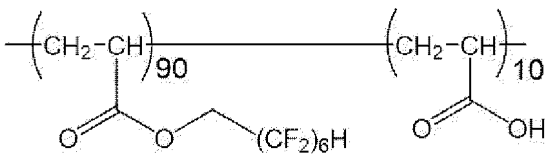

[Comparative Example 2]

[Production of Image Display Device B2 Having Viewing Angle Switching Function]

An image display device B2 having a viewing angle switching function was produced in the same manner as in Comparative Example 1, except that the composition 6 for forming a light absorption anisotropic layer was changed to the following composition 7 for forming a light absorption anisotropic layer.

The transmittance central axis angle θ, the alignment degree at wavelengths of 450, 550, and 650 nm, the difference (ΔS) therebetween, and the haze value of the light absorption anisotropic layer formed of the following composition 7 for forming a light absorption anisotropic layer were measured by the above-described method. The results are shown in Table 2.

Further, it was found that in the produced image display device B1, the twisted angle was switched to 0° and 90° by turning on and off the voltage of the TN liquid crystal cell, and accordingly, the viewing angle could be switched to omnidirectional transmission and omnidirectional light shielding.

| Composition of composition 7 for forming light absorption anisotropic layer | |
|---|---|
| · Dichroic substance D-1 shown above | 0.40 parts by mass |
| · Dichroic substance D-2 shown above | 0.15 parts by mass |
| · Dichroic substance D-3 shown above | 0.63 parts by mass |
| · Polymer liquid crystal compound P-1 shown above | 3.20 parts by mass |
| · Low-molecular-weight liquid crystal compound M-1 shown above | 0.45 parts by mass |
| · IRGACURE OXE-02 (manufactured by BASF SE) | 0.04 parts by mass |
| · Compound E-1 shown above | 0.06 parts by mass |
| · Compound E-2 shown above | 0.06 parts by mass |
| · Surfactant F-2 shown above | 0.015 parts by mass |
| · Surfactant F-3 shown below | 0.01 parts by mass |
| · Cyclopentanone | 85.00 parts by mass |
| · Tetrahydrofuran | 4.50 parts by mass |
| · Benzyl alcohol | 4.50 parts by mass |

Surfactant F-3

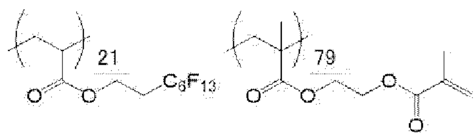

[Comparative Example 3]

[Production of Image Display Device Having Viewing Angle Switching Function]

An image display device B3 having a viewing angle switching function was produced in the same manner as in Example 13 except that the light absorption anisotropic layer A1 was changed to the light absorption anisotropic layer produced in Comparative Example 1.

In the produced image display device B3, it was found that the angle between the in-plane slow axis of the liquid crystal layer in the ISP liquid crystal cell and the transmission axis of the polarizer (the other light absorption anisotropic layer) was switched to 0° and 45° by turning on and off the voltage of the IPS liquid crystal cell, and accordingly, the viewing angle could be switched to up-down light shielding (left-right transmission) and left-right light shielding (up-down transmission).

[Comparative Example 4]

[Production of Image Display Device Having Viewing Angle Switching Function]

An optical laminate was produced in the same condition as in Example 1, except that the composition 1 for

forming a light absorption anisotropic layer was changed to the composition 6 for forming a light absorption anisotropic layer used in Comparative Example 1 and the cooling temperature of 35°C after heating at 120°C was changed to 23°C.

Next, an image display device B4 having a viewing angle switching function was produced in the same manner as in Example 14, except that the optical laminate A1 used in the production of the image display device having a viewing angle switching function of Example 14 was replaced with the above-described optical laminate.

Further, it was found that in the produced image display device B4, the twisted angle was switched to 0° and 90° by turning on and off the voltage of the TN liquid crystal cell, and accordingly, the viewing angle could be switched to omnidirectional transmission and omnidirectional light shielding.

[With Tint of Display Screen]

The difference in tint of the display screen between the image display device (liquid crystal display device) having a viewing angle switching function produced in Examples 1 to 12 and Comparative Examples 1 and 2 and the dynabook (manufactured by Toshiba Corporation) to which the depolarization film were bonded was evaluated according to the following standard. In this case, the observation was performed with the image display in a full white display. The results are shown in Tables 1 to 3 below.

<Evaluation standard>

A: The tint of the display screen of the image display device having a viewing angle switching function is not noticeable with respect to the display screen of the dynabook to which the depolarization film is bonded.
B: The tint of the display screen of the image display device having a viewing angle switching function is slightly noticeable with respect to the display screen of the dynabook to which the depolarization film is bonded.
C: The tint of the display screen of the image display device having a viewing angle switching function is noticeable with respect to the display screen of the dynabook to which the depolarization film is bonded.

[With Tint of Organic EL Display Screen]

The difference in tint of the display screen between the image display device (organic EL display device) having a viewing angle switching function produced in Examples 13 and Comparative Examples 3 and the Galaxy S7+ (manufactured by Samsung Electronics Co., Ltd.) to which the depolarization film were bonded was evaluated according to the following standard. In this case, the observation was performed with the image display in a full white display. The results are shown in Table 3 below.

<Evaluation standard>

A: The tint of the display screen of the image display device having a viewing angle switching function is not noticeable with respect to the display screen of the Galaxy S7+ to which the depolarization film is bonded.
B: The tint of the display screen of the image display device having a viewing angle switching function is slightly noticeable with respect to the display screen of the Galaxy S7+ to which the depolarization film is bonded.
C: The tint of the display screen of the image display device having a viewing angle switching function is noticeable with respect to the display screen of the Galaxy S7+ to which the depolarization film is bonded.

[With Tint of Micro LED Display Screen]

The difference in tint of the display screen between the image display device (micro LED display device) having a viewing angle switching function produced in Example 14 and Comparative Example 4 and the image display device (micro LED display device) having no viewing angle switching function (image display device in which the optical laminate A1 was not placed in the production of the image display device having a viewing angle switching function in Example 14) was evaluated according to the following standard. In this case, the observation was performed with the image display in a full white display. The results are shown in Table 4 below.

<Evaluation standard>

A: The tint of the display screen of the image display device having a viewing angle switching function is not noticeable with respect to the display screen of the micro LED display device having no viewing angle switching function.
B: The tint of the display screen of the image display device having a viewing angle switching function is slightly noticeable with respect to the display screen of the micro LED display device having no viewing angle switching function.
C: The tint of the display screen of the image display device having a viewing angle switching function is noticeable with respect to the display screen of the micro LED display device having no viewing angle switching function.

[Table 1]

| | | | Example 1 | Example 2 | Example 3 | Example 4 | Example 5 | Example 6 | Example 7 |
|---|---|---|---|---|---|---|---|---|---|
| Image display device having viewing angle switching function | | | A1 | A2 | A3 | A4 | A5 | A6 | A7 |
| Light absorption anisotropic layer | Transmittance central axis angle θ | | 0° | 0° | 0° | 0° | 0° | 0° | 0° |
| | Alignment degree | 450nm | 0.940 | 0.945 | 0.945 | 0.940 | 0.940 | 0.940 | 0.940 |
| | | 550nm | 0.965 | 0.965 | 0.970 | 0.965 | 0.965 | 0.965 | 0.965 |
| | | 650nm | 0.955 | 0.955 | 0.960 | 0.955 | 0.955 | 0.955 | 0.955 |
| | | ΔS | 0.025 | 0.020 | 0.025 | 0.025 | 0.025 | 0.025 | 0.025 |
| | Haze value | | 0.4% | 0.4% | 0.3% | 0.4% | 0.4% | 0.4% | 0.4% |
| Number of layers of light absorption anisotropic layer described above | | | Two layer | Two layer | Two layer | Single layer | Single layer | Single layer | Single layer |
| Image display device having viewing angle switching function | Liquid crystal cell mode | | TN | TN | TN | TN | VA | VA | IPS |
| | Switching direction of liquid crystal cell | | Twisted angle 0°↔90° | Twisted angle 0°↔90° | Twisted angle 0°↔90° | Twisted angle 0°↔90° | In-plane phase difference 0↔λ/4 | In-plane phase difference 0↔λ/2 | Angle formed between in-plane slow axis of liquid crystal layer and transmission axis of polarizer (in-plane phase difference: λ/2) |
| | Switching direction of viewing angle | | Omnidirectional transmission ↔ Omnidirectional light shielding | Omnidirectional transmission ↔ Omnidirectional light shielding | Omnidirectional transmission ↔ Omnidirectional light shielding | Up-down light shielding ↔ Left-right light shielding | Up-down light shielding ↔ Omnidirectional transmission | Up-down light shielding ↔ Left-right light shielding | Up-down light shielding ↔ Left-right light shielding |
| Suppression of coloration | | | B | A | A | A | A | A | A |

[Table 2]

| | | | Example 8 | Example 9 | Example 10 | Example 11 | Comparative Example 1 | Comparative Example 2 |
|---|---|---|---|---|---|---|---|---|
| Image display device having viewing angle switching function | | | A8 | A9 | A10 | A11 | B1 | B2 |
| Light absorption anisotropic layer | Transmittance central axis angle θ | | 15° | 0° | 0° | 0° | 0° | 0° |
| | Alignment degree | 450nm | 0.885 | 0.880 | 0.905 | 0.910 | 0.895 | 0.935 |
| | | 550nm | 0.900 | 0.900 | 0.930 | 0.930 | 0.925 | 0.965 |
| | | 650nm | 0.910 | 0.905 | 0.925 | 0.935 | 0.920 | 0.955 |
| | | ΔS | 0.025 | 0.025 | 0.025 | 0.025 | 0.030 | 0.030 |
| | Haze value | | 0.4% | 0.5% | 0.6% | 0.7% | 0.4% | 0.4% |
| Number of layers of light absorption anisotropic layer described above | | | Two layer | Two layer | Two layer | Two layer | Two layer | Two layer |
| Image display device having viewing angle switching function | Liquid crystal cell mode | | TN | TN | TN | TN | TN | TN |
| | Switching direction of liquid crystal cell | | Twisted angle 0°↔90° | Twisted angle 0°↔90° | Twisted angle 0°↔90° | Twisted angle 0°↔90° | Twisted angle 0°↔90° | Twisted angle 0°↔90° |
| | Switching direction of viewing angle | | Omnidirectional transmission ↔ Omnidirectional light shielding | Omnidirectional transmission ↔ Omnidirectional light shielding | Omnidirectional transmission ↔ Omnidirectional light shielding | Omnidirectional transmission ↔ Omnidirectional light shielding | Omnidirectional transmission ↔ Omnidirectional light shielding | Omnidirectional transmission ↔ Omnidirectional light shielding |
| Suppression of coloration | | | B | B | B | B | C | C |

[Table 3]

| | | | Example 12 | Example 13 | Comparative Example 3 |
|---|---|---|---|---|---|
| Image display device having viewing angle switching function | | | A12 | A13 | B3 |
| Light absorption anisotropic layer | Transmittance central axis angle θ | | 0° | 0° | 0° |
| | Alignment degree | 450nm | 0.940 | 0.940 | 0.895 |
| | | 550nm | 0.965 | 0.965 | 0.925 |
| | | 650nm | 0.955 | 0.955 | 0.920 |
| | | ΔS | 0.025 | 0.025 | 0.030 |
| | Haze value | | 0.4% | 0.4% | 0.4% |
| Number of layers of light absorption anisotropic layer described above | | | Single layer | Single layer | Single layer |
| Presence or absence of image display device | | | Presence | Absence | Absence |
| Type of image display device | | | Crystal liquid display device | Organic EL display device | Organic EL display device |
| Image display device having viewing angle switching function | Liquid crystal cell mode | | IPS | IPS | IPS |
| | Switching direction of liquid crystal cell | | Angle formed between in-plane slow axis of liquid crystal layer and transmission axis of polarizer 0°↔45° (in-plane phase difference: λ/2) | Angle formed between in-plane slow axis of liquid crystal layer and transmission axis of polarizer 0°↔45° (in-plane phase difference: λ/2) | Angle formed between in-plane slow axis of liquid crystal layer and transmission axis of polarizer 0°↔45° (in-plane phase difference: λ/2) |
| | Switching direction of viewing angle | | Up-down light shielding ↔ Left-right light shielding | Up-down light shielding ↔ Left-right light shielding | Up-down light shielding ↔ Left-right light shielding |
| Suppression of coloration | | | A | A | C |

[Table 4]

| | | | Example 14 | Comparative Example 4 |
|---|---|---|---|---|
| Image display device having viewing angle switching function | | | A14 | B4 |
| Light absorption anisotropic layer | Transmittance central axis angle θ | | 0° | 0° |
| | Alignment degree | 450nm | 0.940 | 0.895 |
| | | 550nm | 0.965 | 0.925 |
| | | 650nm | 0.955 | 0.920 |
| | | ΔS | 0.025 | 0.030 |
| | Haze value | | 0.4% | 0.4% |
| Number of layers of light absorption anisotropic layer described above | | | Two layer | Two layer |
| Type of image display device | | | Micro LED display device | Micro LED display device |
| Image display device having viewing angle switching function | Liquid crystal cell mode | | TN | TN |
| | Switching direction of liquid crystal cell | | Twisted angle 0°↔90° | Twisted angle 0°↔90° |
| | Switching direction of viewing angle | | Omnidirectional transmission ↔ Omnidirectional light shielding | Omnidirectional transmission ↔ Omnidirectional light shielding |
| Suppression of coloration | | | B | C |

From the results shown in Tables 1 to 4, it was found that, in a case where the difference in the alignment degrees of the light absorption anisotropic layer at wavelengths of 450 nm, 550 nm, and 650 nm was more than 0.025, the tinting of the display screen occurred (Comparative Examples 1 to 4).

On the other hand, it was found that, in a case where an optical laminate in which at least one of the first light absorption anisotropic layer or the second light absorption anisotropic layer was a specific light absorption anisotropic layer that specifies Requirements 1 to 3 described above was used, the tinting of the display screen in a case of being used in an image display device having a viewing angle switching function could be suppressed (Examples 1 to 14).

In particular, from the comparison between Example 1 and Example 2, it was found that, in a case where the difference (ΔS) in the alignment degree of the specific light absorption anisotropic layer at wavelengths of 450 nm, 550 nm, and 650 nm was 0.020 or less, the tinting of the display screen could be further suppressed.

In addition, from the comparison between Example 1 and Example 8, it was found that, in a case where the transmittance central axis angle θ was 0° or more and less than 15°, the tinting of the display screen could be further suppressed.

Explanation of References

12c: EL substrate
12R: R light emitting element
12G: G light emitting element
12B: B light emitting element
24: light emitting unit

## Claims

1. An optical laminate comprising, in the following order:

   a first light absorption anisotropic layer;
   a liquid crystal cell; and
   a second light absorption anisotropic layer,
   wherein at least one of the first light absorption anisotropic layer or the second light absorption anisotropic layer is a specific light absorption anisotropic layer satisfying all of the following requirements 1 to 3,
   Requirement 1: Contain a dichroic substance,
   Requirement 2: An angle between a transmittance central axis of a light absorption anisotropic layer and a normal direction of a surface of a light absorption anisotropic layer is 0° or more and 40° or less, and
   Requirement 3: A difference in alignment degrees of a light absorption anisotropic layer at wavelengths of 450 nm, 550 nm, and 650 nm is 0.025 or less.

2. The optical laminate according to claim 1,
   wherein a transmittance central axis in any one of the first light absorption anisotropic layer or the second light absorption anisotropic layer is present in an in-plane direction of the light absorption anisotropic layer.

3. The optical laminate according to claim 1,
   wherein a haze value of the specific light absorption anisotropic layer is 0.3% or less.

4. The optical laminate according to claim 1,
   wherein the specific light absorption anisotropic layer contains a polymer liquid crystal compound.

5. The optical laminate according to claim 1,
   wherein the specific light absorption anisotropic layer contains a fluorine-based vertical alignment agent having a boronic acid group.

6. The optical laminate according to claim 1,
   wherein the liquid crystal cell is in a VA mode, and an in-plane phase difference at a wavelength of 550 nm is switchable between 0 nm and 120 to 160 nm or between 0 nm and 250 to 300 nm.

7. The optical laminate according to claim 1,
   wherein the liquid crystal cell is in an IPS mode and has an in-plane phase difference of 120 to 160 nm or 250 to 300 nm at a wavelength of 550 nm.

8. The optical laminate according to claim 1,
   wherein the liquid crystal cell is in a TN mode, and a twisted angle of alignment is switchable between 0° and 90° or between 0° and 270°.

9. An image display device having a viewing angle switching function, the image display device comprising:
   the optical laminate according to any one of claims 1 to 8.

10. The image display device according to claim 9,
    wherein viewing angles of a plurality of regions in a display screen are independently switchable.

FIG. 1

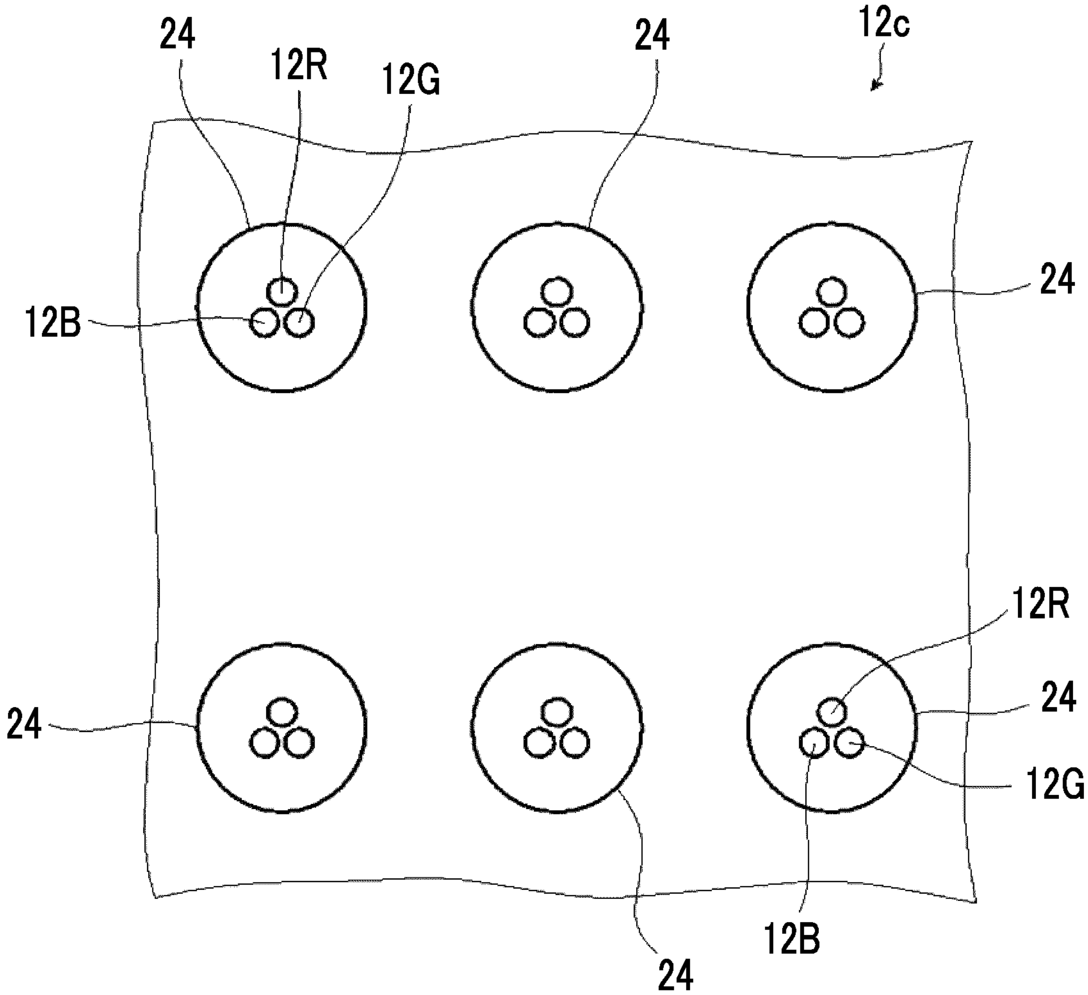

## INTERNATIONAL SEARCH REPORT

International application No.
**PCT/JP2023/041506**

**A. CLASSIFICATION OF SUBJECT MATTER**

***G02B 5/30***(2006.01)i; ***G02F 1/1335***(2006.01)i; ***G09F 9/00***(2006.01)i; ***H10K 59/10***(2023.01)i; ***H10K 59/50***(2023.01)i
FI: G02B5/30; G02F1/1335; G09F9/00 313; H10K59/10; H10K59/50

According to International Patent Classification (IPC) or to both national classification and IPC

**B. FIELDS SEARCHED**

Minimum documentation searched (classification system followed by classification symbols)

G02B5/30; G02F1/1335; G09F9/00; H10K59/10; H10K59/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| Y | WO 2021/210359 A1 (FUJIFILM CORP.) 21 October 2021 (2021-10-21) claims, paragraphs [0022], [0038], [0130] | 1-10 |
| Y | WO 2021/131792 A1 (FUJIFILM CORP.) 01 July 2021 (2021-07-01) paragraphs [0016], [0017], [0253] | 1-10 |
| Y | JP 2012-103719 A (NITTO DENKO CORP.) 31 May 2012 (2012-05-31) claim 1 | 2 |
| Y | JP 2020-143301 A (FUJIFILM CORP.) 10 September 2020 (2020-09-10) claims, paragraph [0105] | 5 |
| A | WO 2021/246441 A1 (FUJIFILM CORP.) 09 December 2021 (2021-12-09) entire text | 1-10 |
| A | WO 2022/138504 A1 (FUJIFILM CORP.) 30 June 2022 (2022-06-30) paragraphs [0240], [0242] | 1-10 |
| A | WO 2018/003380 A1 (FUJIFILM CORP.) 04 January 2018 (2018-01-04) entire text, all drawings | 1-10 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 December 2023** | **09 January 2024** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2023/041506**

**C. DOCUMENTS CONSIDERED TO BE RELEVANT**

| Category* | Citation of document, with indication, where appropriate, of the relevant passages | Relevant to claim No. |
|---|---|---|
| A | JP 2008-203565 A (SHARP KABUSHIKI KAISHA) 04 September 2008 (2008-09-04) entire text, all drawings | 1-10 |
| A | US 2020/0249504 A1 (SHARP CORP.) 06 August 2020 (2020-08-06) entire text, all drawings | 1-10 |
| A | CN 115128855 A (INFOVISION OPTOELECTRONICS (KUNSHAN) CO., LTD.) 30 September 2022 (2022-09-30) entire text, all drawings | 1-10 |

Form PCT/ISA/210 (second sheet) (January 2015)

**INTERNATIONAL SEARCH REPORT**
**Information on patent family members**

International application No.
**PCT/JP2023/041506**

| Patent document cited in search report | Publication date (day/month/year) | Patent family member(s) | Publication date (day/month/year) |
|---|---|---|---|
| WO 2021/210359 A1 | 21 October 2021 | US 2023/0099442 A1<br>claims, paragraphs [0062], [0098], [0381]<br>CN 115443424 A | |
| WO 2021/131792 A1 | 01 July 2021 | US 2022/0342134 A1<br>paragraphs [0060]-[0063], table 1<br>EP 4083668 A1<br>CN 114930206 A | |
| JP 2012-103719 A | 31 May 2012 | (Family: none) | |
| JP 2020-143301 A | 10 September 2020 | US 2019/0218324 A1<br>claims, paragraph [0205]<br>WO 2018/062077 A1<br>CN 109790257 A<br>KR 10-2019-0045247 A | |
| WO 2021/246441 A1 | 09 December 2021 | US 2023/0120853 A1<br>entire document<br>CN 115943331 A | |
| WO 2022/138504 A1 | 30 June 2022 | (Family: none) | |
| WO 2018/003380 A1 | 04 January 2018 | US 2019/0154896 A1<br>entire document | |
| JP 2008-203565 A | 04 September 2008 | (Family: none) | |
| US 2020/0249504 A1 | 06 August 2020 | (Family: none) | |
| CN 115128855 A | 30 September 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021210359 A
- JP 2013228706 A
- JP 2013227532 A
- JP 2013209367 A
- JP 2013014883 A
- JP 2013109090 A
- JP 2013101328 A
- JP 2013037353 A
- JP 2012063387 A
- JP 11305036 A
- JP H11305036 A
- JP 2001133630 A
- JP 2011215337 A
- JP 2010106242 A
- JP 2010215846 A
- JP 2011048311 A
- JP 2011213610 A
- JP 2011237513 A
- JP 2016006502 A
- JP 2018053167 A
- JP 2020011716 A
- WO 2016060173 A
- WO 2016136561 A
- WO 2017154835 A
- WO 2017154695 A
- WO 2017195833 A
- WO 2018164252 A
- WO 2018186503 A
- WO 2019189345 A
- WO 2019225468 A
- WO 2020004106 A
- WO 2021044843 A
- WO 2018199096 A
- JP 2008107767 A
- JP 2007234651 A
- JP 2008019240 A
- JP 2008214269 A
- JP 2006215437 A
- WO 2015166991 A
- JP 2005351924 A


### Non-patent literature cited in the description


- Polymer Handbook. John Wiley & Sons, Inc